(19) **Europäisches Patentamt**

**European Patent Office**

**Office européen des brevets**

(11) **EP 0 864 098 B1**

(12) **EUROPÄISCHE PATENTSCHRIFT**

(45) Veröffentlichungstag und Bekanntmachung des Hinweises auf die Patenterteilung:
**19.01.2000 Patentblatt 2000/03**

(21) Anmeldenummer: **96945546.8**

(22) Anmeldetag: **18.11.1996**

(51) Int Cl.⁷: $G01R\ 31/02$, $G01R\ 31/28$

(86) Internationale Anmeldenummer:
**PCT/DE96/02184**

(87) Internationale Veröffentlichungsnummer:
**WO 97/20222 (05.06.1997 Gazette 1997/24)**

(54) **VERFAHREN UND ANORDNUNG ZUM MESSEN EINER MESSGRÖSSE, INSBESONDERE EINES ELEKTRISCHEN STROMES, MIT HOHER MESSAUFLÖSUNG**

PROCESS AND DEVICE FOR MEASURING A QUANTITY, IN PARTICULAR AN ELECTRIC CURRENT, WITH A HIGH MEASUREMENT RESOLUTION

PROCEDE ET DISPOSITIF DE MESURE D'UNE GRANDEUR, NOTAMMENT UN COURANT ELECTRIQUE, AVEC UNE HAUTE RESOLUTION DE MESURE

(84) Benannte Vertragsstaaten:
**CH DE FR GB IT LI**

(30) Priorität: **30.11.1995 DE 19544778**

(43) Veröffentlichungstag der Anmeldung:
**16.09.1998 Patentblatt 1998/38**

(73) Patentinhaber: **SIEMENS AKTIENGESELLSCHAFT**
**80333 München (DE)**

(72) Erfinder:
• **BOSSELMANN, Thomas**
**D-91054 Erlangen (DE)**
• **BEIERL, Ottmar**
**D-91086 Aurachtal (DE)**

(56) Entgegenhaltungen:
**EP-A- 0 361 832    FR-A- 2 492 986**

• **OPTICS LETTERS, Bd. 16, Nr. 12, 15.Juni 1991, Seiten 955-957, XP000216275 BUSH S P ET AL: "DUAL-CHANNEL FARADAY-EFFECT CURRENT SENSOR CAPABLE OF SIMULTANEOUS MEASUREMENT OF TWO INDEPENDENT CURRENTS"**

EP 0 864 098 B1

**Beschreibung**

Die Erfindung betrifft ein Verfahren und eine Anordnung zum Messen einer Meßgröße.

Es sind optische Meßanordnungen zum Messen eines elektrischen Stromes in einem Stromleiter bekannt, die auf dem magnetooptischen Faraday-Effekt beruhen und deshalb auch als magnetooptische Stromwandler bezeichnet werden. Bei einem magnetooptischen Stromwandler wird linear polarisiertes Meßlicht durch ein in der Nähe des Stromleiters angeordnetes Faraday-Element gesendet, das aus einem den Faraday-Effekt zeigenden, optisch transparenten Material besteht. Das von dem Strom erzeugte Magnetfeld bewirkt eine Drehung der Polarisationsebene des Meßlichts um einen Drehwinkel $\rho$, der proportional zum Wegintegral über das Magnetfeld entlang des vom Meßlicht zurückgelegten Weges ist. Die Proportionalitätskonstante nennt man Verdet-Konstante V. Die Verdet-Konstante V hängt im allgemeinen vom Material und der Temperatur des Faraday-Elements und von der Wellenlänge des verwendeten Meßlichts ab. Im allgemeinen umgibt das Faraday-Element den Stromleiter, so daß das Meßlicht den Stromleiter in einem praktisch geschlossenen Weg wenigstens einmal umläuft. Der Drehwinkel $\rho$ ist in diesem Fall im wesentlichen direkt proportional zur Amplitude I des zu messenden Stromes gemäß der Beziehung

$$\rho = N \cdot V \cdot I \qquad (1),$$

wobei N die Zahl der Umläufe des Meßlichts um den Stromleiter ist. Der Faraday-Drehwinkel $\rho$ wird polarimetrisch durch eine Polarisationsanalyse des durch das Faraday-Element gelaufenen Meßlichts bestimmt, um ein Meßsignal für den elektrischen Strom zu erhalten. Zur Polarisationsanalyse sind eine einkanalige Polarisationsauswertung und eine zweikanalige Polarisationsauswertung bekannt.

Bei einer einkanaligen Polarisationsauswertung wird das Meßlicht nach Durchlaufen des Faraday-Elements einem Polarisator als Analysator zugeführt und das vom Polarisator durchgelassene Meßlicht von einem photoelektrischen Wandler in ein elektrisches Signal als Meßsignal S umgewandelt. Dieses Meßsignal S entspricht der Lichtintensität der auf die Polarisationsachse (Transmissionsachse) des Polarisators projizierten Lichtkomponente des Meßlichts und hat bei Vernachlässigung von Störeinflüssen wie Temperaturänderungen und Vibrationen die allgemeine Form

$$S = S_0/2 \cdot (1 + \sin(2\rho + \psi)) =$$

$$= S_0/2 \cdot (1 + \sin(2 \cdot N \cdot V \cdot I + \psi)) \qquad (2).$$

Dabei ist $S_0$ die konstante Maximalamplitude des Meßsignals S, die dem Fall entspricht, wenn die Polarisationsebene des Meßlichts parallel zur Polarisationsachse des Polarisators ist (maximale transmittierte Lichtintensität). $\psi$ ist ein konstanter Off-set-Winkel für einen Strom Null (I = 0 A) und hängt von dem Polarisatorwinkel zwischen der Polarisationsebene des Meßlichts beim Einkoppeln in das Faraday-Element und der Polarisationsachse des Analysators ab. Wenn dieser Polarisatorwinkel gleich 45° ist, so ist $\psi=0$ *(IEEE Transactions on Power Delivery, Vol. 7, No. 2, April 1992, Seiten 848 bis 852)*

Bei einer zweikanaligen Polarisationsauswertung wird das Meßlicht nach Durchlaufen des Faraday-Elements von einem Analysator in zwei linear polarisierte Lichtkomponenten L1 und L2 mit senkrecht zueinander gerichteten Polarisationsebenen zerlegt. Als Analysator sind polarisierende Strahlteiler wie beispielsweise ein Wollaston-Prisma oder auch ein einfacher Strahlteiler mit zwei nachgeschalteten Polarisatoren, deren Polarisationsachsen um $\pi/2$ bzw. 90° gegeneinander verdreht sind, bekannt. Beide Lichtkomponenten L1 und L2 werden von jeweils einem zugeordneten photoelektrischen Wandler in jeweils ein elektrisches Intensitätssignal T1 oder T2 umgewandelt, das proportional zur Lichtintensität der jeweiligen Lichtkomponente L1 bzw. L2 ist. Aus diesen beiden elektrischen Signalen wird ein Meßsignal

$$T = (T1 - T2)/(T1 + T2) \qquad (3)$$

gebildet, das dem Quotienten aus einer Differenz und der Summe der beiden Intensitätssignale T1 und T2 entspricht *(WO 95/10046)*. Dieses Meßsignal T ist bei Vernachlässigung von Störeinflüssen gleich

$$T = \sin(2\rho + \zeta) = \sin(2 \cdot N \cdot V \cdot I + \zeta) \qquad (4),$$

EP 0 864 098 B1

wobei $\zeta$ ein von dem Winkel zwischen der Polarisationsebene des Meßlichts beim Einkoppeln in das Faraday-Element und einer ausgezeichneten optischen Eigenachse des Analysators abhängiger Off-set-Winkel für I = 0 A ist.

Sowohl bei einer einkanaligen als auch bei einer zweikanaligen Polarisationsanalyse ist das Meßsignal S gemäß Gleichung (1) bzw. T gemäß Gleichung (4) somit eine periodische, sinusförmige Funktion des doppelten Drehwinkels $2\rho$ mit der Periode $\pi$. Es gilt also

$$S(\rho + n\ \pi) = S(\rho) \text{ und } T(\rho + n\ \pi) = T(\rho)$$

mit der ganzen Zahl n. Die Periodizität der Meßsignale S und T ist eine Folge davon, daß um ein ganzzahliges Vielfaches von $\pi$ bzw. 180° gegeneinander gedrehte Polarisationsebenen des Meßlichts polarimetrisch nicht voneinander unterschieden werden können.

So kommt es, daß zwar der Faraday-Meßwinkel $\rho$ selbst gemäß Gleichung (1) eine lineare und damit eindeutige Funktion des Stromes I ist, die Meßsignale S und T eines polarimetrischen magnetooptischen Stromwandlers dagegen nur über einem maximal $\pi/2$ (bzw. 90°) großen Winkelbereich für den Meßwinkel $\rho$ eindeutige Funktionen des Meßwinkels $\rho$ sind. Mit den bekannten polarimetrischen magnetooptischen Stromwandlern sind deshalb nur solche elektrische Ströme eindeutig meßbar, die in einem dem genannten maximal $\pi/2$ (bzw. 90°) großen Winkelbereich für den Meßwinkel $\rho$ entsprechenden Strommeßbereich (Strommeßintervall, measuring range)) MR der Intervallänge |MR| liegen. Der Strommeßbereich MR ist gemäß Gleichung (1) maximal

$$|MR| = \pi/(2 \cdot N \cdot V) \tag{5}$$

groß. Aus Gleichung (5) ist ersichtlich, daß man die Größe |MR| des Strommeßbereichs MR eines magnetooptischen Stromwandlers durch die Wahl von Materialien mit unterschiedlichen Verdet-Konstanten V für das Faraday-Element und/oder durch die Zahl N der Umläufe des Meßlichts um den Stromleiter einstellen kann. Einen größeren Strommeßbereich erhält man, wenn man das Produkt N·V im Nenner kleiner einstellt. Jedoch zieht eine solche Wahl eines größeren Strommeßbereichs MR unweigerlich eine verringerte Meßauflösung (measuring resolution) MA des Stromwandlers bei vorgegebener Anzeigeauflösung nach sich. Die Meßauflösung MA ist dabei und im folgenden als Betrag |MS| der Meßempfindlichkeit MS des Stromwandlers definiert. Die Meßempfindlichkeit MS entspricht der Steigung der Kennlinie des magnetooptischen Stromwandlers in einem Arbeitspunkt und ist im Falle der einkanaligen Auswertung gemäß Gleichung (2) gleich

$$MS = dS/dI = S_0 \cdot N \cdot V \cdot \cos(2 \cdot N \cdot V \cdot I + \psi) \tag{6}$$

und bei einer zweikanaligen Auswertung gemäß Gleichung (4) gleich

$$MS = dT/dI = 2 \cdot N \cdot V \cdot \cos(2 \cdot N \cdot V \cdot I + \zeta) \tag{7}.$$

Aus den Gleichungen (6) und (7) erkennt man sofort, daß eine Verkleinerung des Produkts N·V bei beiden Auswerteverfahren zu einer Verringerung der Meßauflösung MA = |MS| führt.

Aus *EP-B-0 088 419* ist ein magnetooptischer Stromwandler bekannt, bei dem zwei Faraday-Glasringe parallel zueinander um einen gemeinsamen Stromleiter angeordnet sind, die aus Faraday-Materialien mit unterschiedlichen Verdet-Konstanten bestehen und somit jeder für sich unterschiedliche Strommeßbereiche aufweisen. Jedem Faraday-Glasring sind jeweils eine Sendeeinheit zum Senden linear polarisierten Meßlichts in den Glasring und eine zweikanalige Auswerteeinheit zum Berechnen eines jeweiligen Meßsignals für den jeweiligen Faraday-Drehwinkel zugeordnet. Die beiden Meßsignale der beiden Auswerteeinheiten werden einem OR-Gatter zugeführt, das ein Maximumssignal aus den beiden Meßsignalen ermittelt. Mit diesem Maximumssignal wird zwischen den Meßbereichen der beiden Glasringe umgeschaltet. Unterschiedliche Meßbereiche der beiden Glasringe können auch bei gleichem Glasmaterial für beide Glasringe erreicht werden, indem Meßlicht unterschiedlicher Wellenlänge verwendet wird. Dabei wird die Wellenlängenabhängigkeit der Faraday-Drehung ausgenutzt.

Aus *"International Conference of Large High Voltage Electric Systems", CIGRE, Paris, 28.8.-3.9.1988, Conference Proceedings, T, Pref. Subj. 1, Vol. 34, Band 15, Seiten 1 bis 10* ist eine faseroptische Meßanordnung mit einem ersten magnetooptischen Stromwandler zum Messen von Nennströmen und mit einem zweiten magnetooptischen Stromwandler zum Messen von Überströmen bekannt. Der erste Stromwandler zum Messen von Nennströmen enthält eine optische Monomode-Faser, die den Stromleiter in Form einer Meßwicklung mit N Windungen umgibt. Linear polarisiertes Licht durchläuft die Meßwicklung, wird von einem Spiegel in die Faser zurückreflektiert und durchläuft die Meßwicklung in umgekehrter Richtung ein zweites Mal (Reflexionstyp). Der Faraday-Drehwinkel wird dabei verdoppelt, während sich die unerwünschten temperaturabhängigen Effekte der zirkularen Doppelbrechung des Fasermaterials gerade herausheben. Nach zweimaligem Durchlaufen der Meßwicklung wird das Licht einer zweikanaligen Polarisationsauswertung unterzogen. Der zweite, für Schutzzwecke vorgesehene magnetooptische Stromwandler umfaßt ebenfalls eine Monomode-Faser, die den Stromleiter in Form einer Meßwicklung mit einer Meßwindung umgibt. Im Gegensatz zum ersten, für Meßzwecke vorgesehenen Stromwandler ist der zweite Stromwandler vom Transmissionstyp, d.h. das linear polarisierte Meßlicht wird nach nur einmaligem Durchlaufen der Meßwindung einer Polarisationsanalyse unterzogen.

Aus "SENSOR 93 *Kongeßband IV B11.1, Seiten 137 bis* 144" ist ein magnetooptischer Stromwandler für Schutzzwecke zum Messen von Wechselströmen bekannt, bei dem linear polarisiertes Licht nach Durchlaufen einer Faraday-Lichtleitfaser in zwei Lichtteilsignale aufgespalten wird und jedes dieser Lichtteilsignale einem Analysator zugeführt wird. Die Eigenachsen (Polarisationsachsen) der beiden Analysatoren sind unter einem Winkel von 45° oder 58° zueinander gerichtet. Die von den Analysatoren durchgelassenen Lichtintensitäten werden erst durch Division durch ihre Gleichanteile normiert, die durch Spitzenwertgleichrichtung erhalten werden. Anschließend wird ein Produkt der normierten Signale gebildet und dieses Produkt dann differenziert. Durch Integration wird direkt der Faraday-Drehwinkel erhalten. Dadurch erhält man ein Signal, das proportional zum Strom ist und daher keinen Meßbereichsbeschränkungen unterliegt. Jedoch ist dieses Verfahren vergleichsweise aufwendig.

Aus der *EP-B-0 208* 593 ist ein magnetooptischer Stromwandler bekannt, bei dem linear polarisiertes Meßlicht nach Durchlaufen einer einen Stromleiter umgebenden Faraday-Lichtleitfaser von einem Strahteiler in zwei Lichtteilsignale aufgeteilt wird und jedes dieser Lichtteilsignale einem Analysator zugeführt wird. Die Eigenachsen der beiden Analysatoren sind unter einem Winkel von 0° bzw. 45° zur Einkoppelpolarisation des Meßlichts, gerichtet. Dadurch erhält man am Ausgang eines Analysators ein erstes, sinusförmiges Signal und am Ausgang des anderen Analysators ein zweites, cosinusförmiges Signal Diese beiden Signale sind jeweils mehrdeutige, oszillierende Funktionen des Stromes im Stromleiter, die um einen Winkel von 90° gegeneinander phasenverschoben sind. Aus diesen beiden mehrdeutigen Signalen wird nun ein eindeutiges Meßsignal zusammengesetzt durch Vergleich der Vorzeichen und der Beträge der Meßwerte des ersten, sinusförmigen Signals und des zweiten, cosinusförmigen Signals. Sobald die Beträge von Sinus und Cosinus gleich sind, d.h. bei einem ganzzahligen Vielfachen von 45°, wird in Abhängigkeit von den Vorzeichen von Sinus und Cosinus von einem eindeutigen Zweig des ersten, sinusförmigen Signals in einen eindeutigen Zweig des zweiten, cosinusförmigen Signals umgeschaltet oder umgekehrt. Dieses Verfahren ist ein inkrementales Verfahren, so daß der Arbeitspunkt bei Strom Null bei einem Ausfall der Elektronik des Stromwandlers erst wieder neu eingestellt werden muß.

Der Erfindung liegt nun die Aufgabe zugrunde, ein Verfahren und eine Anordnung zum Messen einer Meßgröße aus einem vorgegebenen Meßbereich und insbesondere zum Messen eines elektrischen Stromes in einem Stromleiter aus einem vorgegebenen Strommeßbereich anzugeben, bei dem eine hohe Meßauflösung erreicht wird.

Diese Aufgabe wird gemäß der Erfindung gelöst mit den Merkmalen des Anspruchs 1 bzw. des Anspruchs 8.

Das Verfahren zum Messen einer Meßgröße aus einem vorgegebenen Meßbereich umfaßt die folgenden Verfahrensschritte:

a) Ableiten eines ersten Meßsignals für die Meßgröße, das eine in dem vorgegebenen Meßbereich eindeutige Funktion der Meßgröße ist,
b) Ableiten eines zweiten Meßsignals für die Meßgröße, das eine im wesentlichen periodische Funktion der Meßgröße ist mit einer Periode, die kleiner ist als die doppelte Intervallänge des Meßbereichs und
c) Ableiten eines dritten Meßsignals für die Meßgröße aus den beiden genannten Meßsignalen, das im vorgebenen Meßbereich eine eindeutige Funktion der Meßgröße ist und wenigstens die gleiche Meßauflösung wie das zweite Meßsignal aufweist.

Die Anordnung zum Messen einer Meßgröße aus einem vorgegebenen Meßbereich enthält

a) eine erste Meßeinrichtung zum Erzeugen eines ersten Meßsignals, das eine in dem vorgegebenen Meßbereich eindeutige Funktion der Meßgröße ist,
b) eine zweite Meßeinrichtung zum Erzeugen eines zweiten Meßsignals, das eine im wesentlichen periodische Funktion der Meßgröße ist mit einer Periode, die kleiner ist als die doppelte Intervallänge des Meßbereichs und
c) eine mit der ersten Meßeinrichtung und der zweiten Meßeinrichtung verbundene Signalverarbeitungseinheit, die aus dem ersten Meßsignal und dem zweiten Meßsignal ein drittes Meßsignal ableitet, das im vorgegebenen Meßbereich eine eindeutige Funktion der Meßgröße ist und wenigstens die gleiche Meßauflösung wie das zweite Meßsignal aufweist.

Das dritte Meßsignal vereint in sich den Vorteil des größeren Meßbereich**s** des ersten Meßsignals und den Vorteil der höheren Meßauflösung des zweiten Meßsignals und ermöglicht daher eine eindeutige Messung der Meßgröße in dem vorgegebenen Meßbereich mit einer hohen Meßauflösung. Umgekehrt weist das dritte Meßsignal bei vorgegebener Meßauflösung einen großen Meßbereich **auf**. Das Verfahren und die Anordnung sind nicht inkremental. Bei einer Störung oder einem Ausfall des Stromwandlers kann dieser ohne vorherige Eichung direkt wieder in Betrieb genommen werden. Die Funktionszuverlässigkeit ist somit immer gegeben.

Besondere Ausgestaltungen und Weiterbildungen des Verfahrens und der Anordnung gemäß der Erfindung ergeben sich aus den jeweils abhängigen Ansprüchen.

Demnach ist in einer Ausführungsform auch das erste Meßsignal eine periodische Funktion der Meßgröße.

In einer bevorzugten Ausführungsform wird mit Hilfe des ersten Meßsignals der Meßbereich in Eindeutigkeitsbereiche unterteilt, über **die hinweg** das zweite Meßsignal eine eindeutige Funktion der Meßgröße ist, und aus den Zweigen des zweiten Meßsignals in diesen Eindeutigkeitsbereichen das dritte Meßsignal zusammengesetzt _____.

Das dritte Meßsignal kann aus dem ersten Meßsignal und dem zweiten Meßsignal mit Hilfe einer vorab ermittelten Wertetabelle oder auch rechnerisch abgeleitet werden.

Vorzugsweise werden das Meßverfahren und die Meßanordnung zum Messen eines elektrischen Stromes in einem Stromleiter aus einem vorgegebenen Strommeßbereich eingesetzt. Dazu sind wenigstens zwei den Stromleiter umgebende Faraday-Elemente vorgesehen. Ein erstes linear polarisiertes Lichtsignal wird durch ein erstes der beiden Faraday-Elemente wenigstens einmal geschickt, und aus einer Drehung der Polarisationsebene dieses ersten Lichtsignals nach Durchlaufen des ersten Faraday-Elements wird von einer ersten Auswerteeinheit das erste Meßsignal für den Strom abgeleitet. Ein zweites linear polarisiertes Lichtsignal wird wenigstens durch ein zweites der beiden Faraday-Elemente wenigstens einmal gesendet, und aus einer Drehung der Polarisationsebene dieses zweiten Lichtsignals nach Durchlaufen wenigstens des zweiten Faraday-Elements wird von einer zweiten Auswerteeinheit das zweite Meßsignal für den Strom abgeleitet.

In einer besonderen Ausführungsform des Meßverfahrens durchläuft das zweite linear polarisierte Lichtsignal sowohl das erste Faraday-Element als auch das zweite Faraday-Element jeweils wenigstens einmal. Die zweite Meßeinrichtung der Meßanordnung enthält dann auch das erste Faraday-Element der ersten Meßeinrichtung, und die beiden Faraday-Elemente sind über optische Verbindungsmittel optisch in Reihe geschaltet. In dieser Ausführungsform genügt eine Lichtquelle zum Senden von linear polarisiertem Meßlicht, da das Meßlicht von den optischen Verbindungsmitteln in zwei Lichtanteile aufgeteilt wird, von denen ein Lichtanteil als erstes Lichtsignal und der andere Lichtanteil als zweites Lichtsignal vorgesehen werden. Außerdem ist ein kompakter Aufbau der Anordnung möglich, da die beiden Faraday-Elemente raumsparend nebeneinander angeordnet werden können.

Zur weiteren Erläuterung der Erfindung wird auf die Zeichnung Bezug genommen, in deren

FIG 1 ein prinzipieller Aufbau einer Anordnung zum Messen einer Meßgröße aus einem vorgegebenen Meßbereich

FIG 2 in einem Diagramm drei unterschiedliche Meßsignale für die Meßgröße

FIG 3 eine Anordnung zum Messen eines elektrischen Stromes aus einem vorgegebenen Strommeßbereich mit zwei separaten Faraday-Meßeinrichtungen

FIG 4 eine Anordnung zum Messen eines elektrischen Stromes aus einem vorgegebenen Strommeßbereich mit zwei optisch in Reihe geschalteten und jeweils im Transmissionsmodus betriebenen Faraday-Elementen,

FIG 5 eine Recheneinheit zum Bestimmen des zweiten Meßsignals

FIG 6 eine Anordnung zum Messen eines elektrischen Stromes aus einem vorgegebenen Strommeßbereich mit einem in Transmission betriebenen ersten Faraday-Element und einer Reihenschaltung aus diesem ersten Faraday-Element und einem in Reflexion betriebenen zweiten Faraday-Element und

FIG 7 eine Anordnung zum Messen eines elektrischen Stromes aus einem vorgegebenen Strommeßbereich mit einem in Reflexion betriebenen ersten Faraday-Element und einer in Transmission betriebenen Reihenschaltung dieses ersten Faraday-Elements mit einem zweiten Faraday-Element

jeweils schematisch veranschaulicht sind. Einander entsprechende Teile sind mit denselben Bezugszeichen versehen.

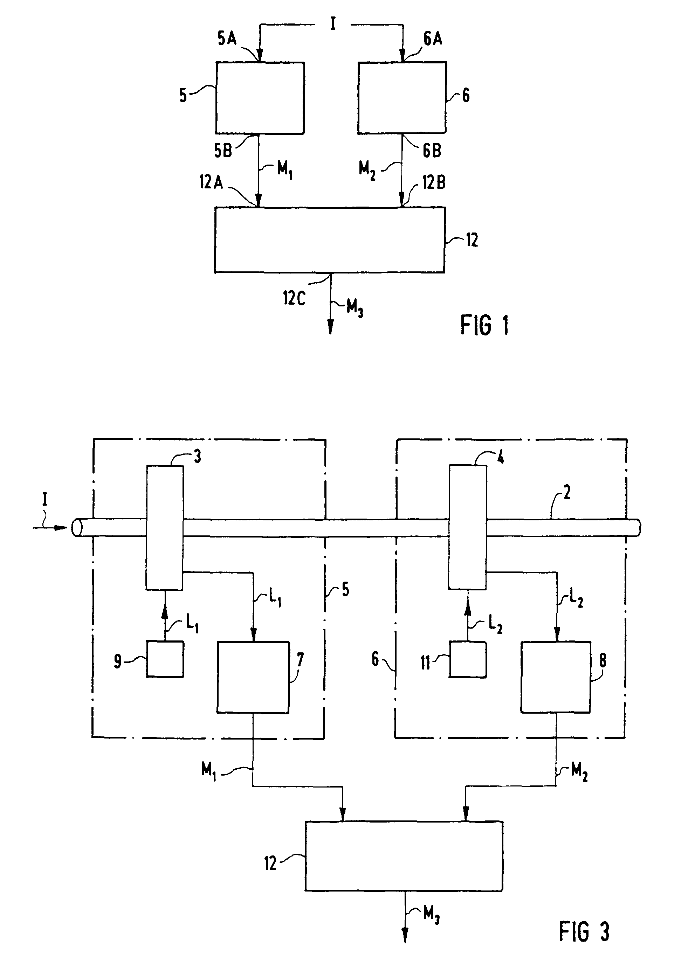

Die FIG 1 zeigt eine Meßanordnung zum Messen einer Meßgröße I in einem vorgegebenen Meßbereich MR. Die Meßanordnung enthält eine erste Meßeinrichtung 5 und eine zweite Meßeinrichtung 6 sowie eine Signalverarbeitungseinheit 12. An einem Eingang 5A der ersten Meßeinrichtung 5 und an einem Eingang 6B der zweiten Meßeinrichtung 6 steht jeweils die Meßgröße I an.

Die erste Meßeinrichtung 5 wandelt die Meßgröße I in ein erstes Meßsignal $M_1$ um, das zumindest über **den** vorgegebenen Meßbereich MR **hinweg** eine eindeutige Funktion der Meßgröße I ist. Damit gilt also

$$M_1 (I_a) \neq M_1 (I_b) \tag{8}$$

für zwei beliebige, voneinander verschiedene Werte $I_a$ und $I_b$ der Meßgröße aus dem vorgegebenen Meßbereich MR. Die erste Meßeinrichtung 5 hat somit eine eindeutige Kennlinie in dem Meßbereich MR. Das erste Meßsignal $M_1$ wird von einem Ausgang 5B der ersten Meßeinrichtung 5 einem ersten Eingang 12A der Signalverarbeitungseinheit 12 zugeführt.

Die zweite Meßeinrichtung 6 erzeugt aus der Meßgröße I ein zweites Meßsignal $M_2$, das zumindest über <u>den</u> vorgegebenen Meßbereich MR <u>hinweg</u> eine periodische Funktion der Meßgröße I mit einer Periode $P_2$ ist. Es gilt also:

$$M_2\,(I) = M_2\,(I + n \cdot P_2) \qquad\qquad (9)$$

mit der ganzen Zahl n, und die Kennlinie der zweiten Meßeinrichtung 6 ist periodisch zumindest über <u>den</u> Meßbereich MR <u>hinweg</u>. Die Periode $P_2$ des zweiten Meßsignals $M_2$ ist kleiner als die doppelte Intervalllänge 2 IMRI des Meßbereichs MR, das heißt

$$P_2 < 2\,|MR| \qquad\qquad (10).$$

Wegen der Bedingung (10) ist das zweite Meßsignal $M_2$ im Gegensatz zum ersten Meßsignal $M_1$ keine eindeutige Funktion der Meßgröße I über <u>den</u> Meßbereich MR <u>hinweg</u>.

Die Meßauflösung

$$MA(M_2) = |dM_2/dI| \qquad\qquad (11)$$

des zweiten Meßsignals $M_2$ und der zweiten Meßeinrichtung 6 ist im Meßbereich MR gegebenenfalls mit Ausnahme einzelner Teilbereiche höher als die Meßauflösung

$$MA(M_1) = |dM_1/dI| \qquad\qquad (12)$$

des ersten Meßsignals $M_1$ und der zugehörigen ersten Meßeinrichtung 5. Das zweite Meßsignal $M_2$ wird von einem Ausgang 6B der zweiten Meßeinrichtung 6 zu einem zweiten Eingang 12B der Signalverarbeitungseinheit 12 übertragen.

Die Signalverarbeitungseinheit 12 bildet nun aus den beiden an ihren Eingängen 12A und 12B anliegenden Meßsignalen $M_1$ und $M_2$ ein drittes Meßsignal $M_3$, das über <u>den</u> gesamten Meßbereich MR <u>hinweg</u> zum einen eine eindeutige Funktion ist und zum anderen wenigstens die Meßauflösung $MA(M_2)$ des zweiten Meßsignals $M_2$ aufweist. Dieses dritte Meßsignal $M_3$ kann an einem Ausgang 12C der Signalverarbeitungseinheit 12 abgegriffen werden.

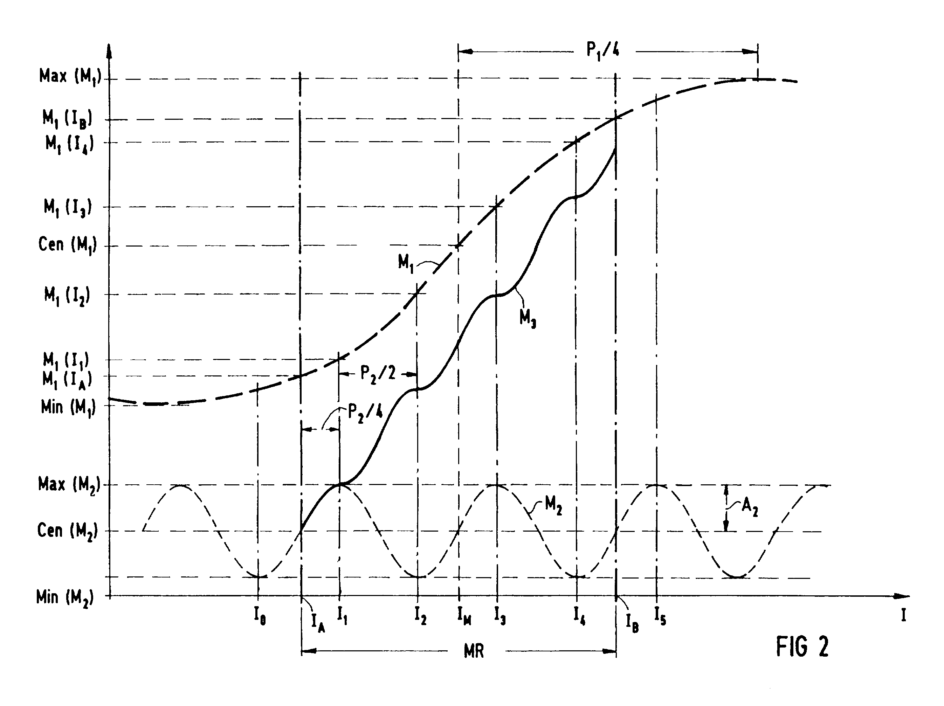

Die FIG 2 zeigt in einem Diagramm ein Ausführungsbeispiel für die drei in einer Meßanordnung gemäß FIG 1 abgeleiteten Meßsignale $M_1$, $M_2$ und $M_3$. Ein vorgegebener Meßbereich für auf der Abszisse aufgetragene Meßgröße I ist mit MR bezeichnet und entspricht einem vorzugsweise geschlossenen Intervall $[I_A, I_B]$ von Werten der Meßgröße I zwischen einer ersten Intervallgrenze $I_A$ und einer zweiten Intervallgrenze $I_B$. Dieser Meßbereich MR hat somit die Länge $|MR| = |\,I_B - I_A\,|$.

Das erste Meßsignal $M_1$ ist eine periodische und vorzugsweise sinusförmige Funktion der Meßgröße I und oszilliert zwischen einem Maximalwert $Max(M_1)$ und einem Minimalwert $Min(M_1)$ mit der Periode $P_1$. Zwischen den beiden Extremwerten $Max(M_1)$ und $Min(M_1)$ durchläuft das erste Meßsignal M den Zentralwert $Cen(M_1) = 0{,}5 \cdot (Max(M_1) + Min(M_1))$. Über <u>den</u> Meßbereich MR <u>hinweg</u> ist das erstes Meßsignal $M_1$ eine eindeutige Funktion der Meßgröße I, d.h. es genügt der Bedingung (8). Im dargestellten Ausführungsbeispiel liegt der Meßbereich MR innerhalb einer halben Periode $P_1/2$ des erstes Meßsignal $M_1$ zwischen dessen Minimalwert $Min(M_1)$ und Maximalwert $Max(M_1)$, in welchem Bereich eine sinusförmige Funktion bekanntlich eindeutig ist, und der Zentralwert $Cen(M_1)$ des erstes Meßsignals $M_1$ entspricht dem Wert des erstes Meßsignals $M_1$ beim Mittelpunkt $I_M = 0{,}5 \cdot (I_B + I_A)$ des Meßbereichs MR, also $Cen(M_1) = M_1(I_M)$. Das erste Meßsignal $M_1$ steigt im Meßbereich MR mit zunehmender Meßgröße I mit einer positiven Steigung streng monoton an, kann aber auch eine streng monoton fallende Funktion mit negativer Steigung sein.

Das zweite Meßsignal $M_2$ ist zumindest über <u>den</u> Meßbereich MR <u>hinweg</u> eine periodische und vorzugsweise sinusförmige Funktion der Meßgröße I und oszilliert zwischen einem Maximalwert $Max(M_2)$ und einem Minimalwert $Min(M_2)$ mit der Periode $P_2$. Drei Werte der Meßgröße I, bei denen das zweite Meßsignal $M_2$ seinen Minimalwert $Min(M_2)$ annimmt, sind mit $I_0$, $I_2$ und $I_4$ bezeichnet, drei Werte, bei denen das zweite Meßsignal $M_2$ seinen Maximalwert

Max($M_2$) annimmt, dagegen mit $I_1$, $I_3$ und $I_5$. Es gilt $I_0 < I_1 < I_2 < I_3 < I_4 < I_5$. Zwischen zwei Extremwerten Max($M_2$) und Min($M_2$) durchläuft das zweite Meßsignal $M_2$ einen Zentralwert Cen($M_2$) = 0,5 · (Max($M_2$) + Min($M_2$)) . Im dargestellten Ausführungsbeispiel umfaßt der Meßbereich MR zwei Perioden 2·$P_2$ des zweiten Meßsignals $M_2$, wobei das zweite Meßsignal $M_2$ an den Randpunkten $I_A$ und $I_B$ sowie am Mittelpunkt $I_M$ des Meßbereichs MR jeweils seinen Mittelwert Cen($M_2$) annimmt, also Cen($M_1$) = $M_1$($I_A$) = $M_1$($I_B$) = $M_1$($I_M$) gilt. Das dargestellte zweite Meßsignal $M_2$ erfüllt somit die vorgenannten Bedingungen (9) und (10).

Das erste Meßsignal $M_1$ ist der besseren Übersichtlichkeit in einem größeren Maßstab dargestellt als das zweite Meßsignal $M_2$, hat also im allgemeinen einen flacheren Verlauf im Vergleich zum zweite Meßsignal $M_2$, und ist überdies versetzt zum zweiten Meßsignal $M_2$ gezeichnet. Die Wertebereiche [Min($M_1$),Max($M_1$)] des ersten Meßsignals $M_1$ und [Min($M_2$),Max($M_2$)] des zweiten Meßsignals $M_2$ können sich auch überschneiden. Insbesondere können die beiden Zentralwerte Cen($M_1$) und Cen($M_2$) gleich sein, vorzugsweise Cen($M_1$) = Cen($M_2$) = 0 in entsprechenden Maßeinheiten. Die Meßauflösung MA($M_1$) des ersten Meßsignals $M_1$ ist über den größten Teil des Meßbereichs MR **hinweg** deutlich kleiner als die Meßauflösung MA($M_2$) des zweiten Meßsignals $M_2$. Eine Ausnahme bilden nur kleine Bereiche um die Werte $I_n$ der Meßgröße I mit n = 0, 1, 2, 3, 4 oder 5, bei denen das zweite Meßsignal $M_2$ seine Extremwerte Max($M_2$) bzw. Min($M_2$)annimmt und bei denen folglich die Meßauflösung des zweiten Meßsignals $M_2$ Null ist, d.h. MA($M_2$($I_n$)) = 0. Die maximale Meßauflösung MA($M_1$($I_M$)) des ersten Meßsignals $M_1$ im Mittelpunkt $I_M$ des Meßbereichs MR ist deutlich kleiner als die maximale Meßauflösung MA($M_2$($I_M$)) des zweiten Meßsignals $M_2$, die im gezeigten Ausführungsbeispiel über **den** Meßbereich MR **hinweg** fünfmal und insbesondere im Mittelpunkt $I_M$ des Meßbereichs MR angenommen wird.

Das dritte Meßsignal $M_3$ wird nun folgendermaßen aus dem ersten Meßsignal $M_1$ und dem zweiten Meßsignal $M_2$ abgeleitet. Der Meßbereich MR kann in einzelne Eindeutigkeitsbereiche unterteilt werden, über **die hinweg** das zweite Meßsignal $M_2$ eine eindeutige Funktion der Meßgröße I ist. Diese Eindeutigkeitsbereiche (Quadranten) sind im dargestellten Diagramm durch Linien voneinander getrennt und entsprechen den Intervallen [$I_A$,$I_1$], [$I_1$,$I_2$], [$I_2$,$I_3$], [$I_3$, $I_4$] und [$I_4$,$I_B$] zwischen zwei benachbarten Extremwerten des zweiten Meßsignals $M_2$. Der erste Eindeutigkeitsbereich [$I_A$,$I_1$] und der letzte Eindeutigkeitsbereich [$I_4$,$I_B$] sind dabei nur $P_2$/4 lang, während die dazwischen liegenden, inneren Eindeutigkeitsbereiche [$I_1$,$I_2$], [$I_2$,$I_3$] und [$I_3$,$I_4$] jeweils die Maximallänge $P_2$/2 aufweisen. Aus dem Meßwert $M_2$(I), den das zweite Meßsignal $M_2$ liefert, allein kann nun jedoch nicht ermittelt werden, in welchem der Eindeutigkeitsbereiche die aktuelle Meßgröße I liegt. Diese Mehrdeutigkeit des zweiten Meßsignals $M_2$ wird nun mit Hilfe des ersten Meßsignals $M_1$ aufgelöst. Die einzelnen Äste des zweiten Meßsignals $M_2$ in den Eindeutigkeitsbereichen werden durch Transformationen (Operationen) wie Translationen und gegebenenfalls Spiegelungen zu dem neuen Meßsignal $M_3$ zusammengesetzt. Diese Operationen sind im allgemeinen für jeden Eindeutigkeitsbereich unterschiedlich. Mit Hilfe des aktuellen Wertes $M_1$(I) des ersten Meßsignals $M_1$ wird nun zunächst der Eindeutigkeitsbereich ermittelt, in welchem der aktuelle Wert der Meßgröße I liegt, und dann mit Hilfe der diesem Eindeutigkeitsbereich zugeordneten Operation der Meßwert $M_3$(I) des dritten Meßsignals $M_3$ für den aktuellen Wert der Meßgröße I ermittelt. Für das dargestellte Ausführungsbeispiel sind insbesondere folgende Operationen zum Ableiten des dritten Meßsignals $M_3$ aus dem zweiten Meßsignal $M_2$ mit Hilfe des ersten Meßsignals $M_1$ geeignet:

$$M_3(I) := M_2(I) \qquad \text{für } M_1(I_A) \leq M_1(I) < M_1(I_1) \qquad\qquad (13a)$$

$$M_3(I) := 2 \cdot A_2 - M_2(I) \qquad \text{für } M_1(I_1) \leq M_1(I) < M_1(I_2) \qquad\qquad (13b)$$

$$M_3(I) := M_2(I) + 4 \cdot A_2 \qquad \text{für } M_1(I_2) \leq M_1(I) < M_1(I_3) \qquad\qquad (13c)$$

$$M_3(I) := 6 \cdot A_2 - M_2(I) \qquad \text{für } M_1(I_3) \leq M_1(I) < M_1(I_4) \qquad\qquad (13d)$$

$$M_3(I) := M_2(I) + 8 \cdot A_2 \qquad \text{für } M_1(I_4) \leq M_1(I) \leq M_1(I_B) \qquad\qquad (13e),$$

wobei $A_2$ die vorgegebene Maximalamplitude des zweiten Meßsignals $M_2$ ist mit

$$A_2 = 0,5 \cdot (\text{Max}(M_2) - \text{Min}(M_2)) \qquad\qquad (14).$$

Wegen der Eindeutigkeit des ersten Meßsignals $M_1$ entsprechen die den Operationen (13a) bis (13e) zugrundeliegenden Bedingungen an den Wert $M_1(I)$ des ersten Meßsignals $M_1$ gerade den Eindeutigkeitsbereichen $[I_A, I_1]$ bis $[I_4, I_B]$ des zweiten Meßsignals $M_2$.

Eine nicht dargestellte weitere Ausführungsform zum Ableiten des dritten Meßsignals $M_3$ ist durch folgende Operationen gegeben, bei denen das zweite Meßsignal $M_2$ im Gegensatz zum dargestellten Ausführungsbeispiel in den Eindeutigkeitsbereichen nicht gespiegelt wird:

$$M_3(I) := M_2(I) \qquad \text{für } M_1(I_A) \leq M_1(I) < M_1(I_1) \qquad\qquad (15a)$$

$$M_3(I) := M_2(I) + 2 \cdot A_2 \qquad \text{für } M_1(I_1) \leq M_1(I) < M_1(I_2) \qquad\qquad (15b)$$

$$M_3(I) := M_2(I) + 4 \cdot A_2 \qquad \text{für } M_1(I_2) \leq M_1(I) < M_1(I_3) \qquad\qquad (15c)$$

$$M_3(I) := M_2(I) + 6 \cdot A_2 \qquad \text{für } M_1(I_3) \leq M_1(I) < M_1(I_4) \qquad\qquad (15d)$$

$$M_3(I) := M_2(I) + 8 \cdot A_2 \qquad \text{für } M_1(I_4) \leq M_1(I) \leq M_1(I_B) \qquad\qquad (15e).$$

Bei dieser Ausführungsform gemäß den Operationen (15a) bis (15e) sind die einzelnen Äste des resultierenden dritten Meßsignals $M_3$ im Gegensatz zum gezeigten Ausführungsbeispiel gemäß den Operationen (13a) bis (13e) nicht stetig aneinandergesetzt.

Die Operationen (13a) bis (13e) oder (15a) bis (15e) können insbesondere mit Hilfe einer vorab experimentell oder durch Berechnungen ermittelten Wertetabelle (Look-up table) durchgeführt werden. Die Wertetabelle ordnet dem Wertepaar der gemessenen Werte $M_1(I)$ und $M_2(I)$ des ersten Meßsignals $M_1$ bzw. zweiten Meßsignals $M_2$ einen Wert $M_3(I)$ des dritten Meßsignals $M_3$ als eindeutiges Maß für die gemessene Meßgröße I zu. Die Signalverarbeitungseinheit 12 enthält dann vorzugsweise einen Speicher zum Speichern der vorab ermittelten Werte der Wertetabelle, einen Analog/Digital-Wandler zum Umwandeln der aktuellen Werte des ersten Meßsignals $M_1$ und des zweiten Meßsignals $M_2$ in jeweils einen Digitalwert und einen digitalen Signalprozessor oder Mikroprozessor zum Vergleichen dieser gemessenen Digitalwerte mit den in der Wertetabelle gespeicherten Werten und Zuordnen des ebenfalls digitalen Wertes $M_3(I)$.

Die genannten Operationen (13a) bis (13e) oder (15a) bis (15e) können aber auch rechnerisch durchgeführt werden. Der gemessene Wert $M_1(I)$ des ersten Meßsignals $M_1$ wird dann mit den vorab ermittelten Werten des ersten Meßsignals $M_1$ an den Intervallgrenzen $I_n$ der Eindeutigkeitsbereiche verglichen, und in Abhängigkeit von diesem Vergleich wird das zweite Meßsignal $M_2$ der zugehörigen arithmetischen Operation unterzogen. Die Signalverarbeitungseinheit 12 enthält in dieser Ausführungsform beispielsweise eine entsprechende Anzahl von Komparatorschaltungen zum Vergleichen des aktuellen Wert $M_1(I)$ des ersten Meßsignals $M_1$ mit den vorab ermittelten Werten des ersten Meßsignals $M_1$ an den Intervallgrenzen $I_n$ der Eindeutigkeitsbereiche und eine analoge Recheneinheit mit analogen Komponeneten wie Subtrahierern, Addierern und Invertierern oder einen Analog/Digital-Wandler und eine nachgeschaltete digitale Recheneinheit zum Durchführen der arithmetischen Operationen. Alternativ dazu kann die Signalverarbeitungseinheit 12 auch einen Analog/Digital-Wandler zum Umwandeln der aktuellen Werte des ersten Meßsignals $M_1$ und des zweiten Meßsignals $M_2$ in jeweils einen Digitalwert und einen nachgeschalteten digitalen Signalprozessor oder Mikroprozessor enthalten, der den digitalen Wert des ersten Meßsignals $M_1$ mit den gespeicherten Digitalwerten $M_1(I_n)$ an den Intervallgrenzen $I_n$ vergleicht und dann die zugehörigen digitalen Rechenoperationen durchführt.

Der aktuelle Wert der Meßgröße I kann nun eindeutig aus dem erhaltenen dritten Meßsignal $M_3$ bestimmt werden durch Anwenden der Umkehrfunktion $M_3^{-1}$ des dritten Meßsignals $M_3$ auf den ermittelten Wert $M_3(I)$ des dritten Meßsignals $M_3$, denn es gilt $M_3^{-1}(M_3(I)) = I$.

Bei dem dargestellten sinusförmigen zweiten Meßsignal $M_2$ mit der Amplitude $A_2$ und der Periode $P_2$ ergibt sich beispielsweise als Meßwert I für die Meßgröße:

$$I = I_{OS}(M_1) + I(M_2) \qquad\qquad (16),$$

wobei sich der Meßwert I aus einem vom ersten Meßsignal $M_1$ abhängigen, für einen Eindeutigkeitsbereich jeweils konstanten Offset-Meßwert $I_{OS}(M_1)$ und einem vom zweiten Meßsignal $M_2$ kontinuierlich abhängigen Anteil $I(M_2)$ zusammensetzt.

Der in den Eindeutigkeitsbereichen des zweiten Meßsignals $M_2$ jeweils konstante Offset-Meßwert $I_{OS}(M_1)$ des Meßwertes I ist im dargestellten Ausführungsbeispiel gemäß den Operationen (13a) bis (13e) sowie auch im Ausführungsbeispiel gemäß den Operationen (15a) bis (15e) gleich

$$I_{OS}(M_1) = I_A \qquad \text{für } M_1(I_A) \leq M_1(I) < M_1(I_1) \tag{17a}$$

$$I_{OS}(M_1) = I_A + 0{,}5\,P_2 \qquad \text{für } M_1(I_1) \leq M_1(I) < M_1(I_2) \tag{17b}$$

$$I_{OS}(M_1) = I_A + P_2 \qquad \text{für } M_1(I_2) \leq M_1(I) < M_1(I_3) \tag{17c}$$

$$I_{OS}(M_1) = I_A + 1{,}5\,P_2 \qquad \text{für } M_1(I_3) \leq M_1(I) < M_1(I_4) \tag{17d}$$

$$I_{OS}(M_1) = I_A + 2\,P_2 \qquad \text{für } M_1(I_4) \leq M_1(I) \leq M_1(I_B) \tag{17e}.$$

Der in den Eindeutigkeitsbereichen des zweiten Meßsignals $M_2$ kontinuierlich veränderliche Anteil $I(M_2)$ beträgt

$$I(M_2) = (P_2/2\pi)\,\arcsin(M_2/A_2) \tag{18a}$$

für

$$M_1(I_A) \leq M_1(I) < M_1(I_1) \text{ oder}$$

$$M_1(I_2) \leq M_1(I) < M_1(I_3) \text{ oder}$$

$$M_1(I_4) \leq M1(I) < M_1(I_B)$$

und

$$I(M_2) = (P_2/2\pi)\,\arcsin(-\,M_2/A_2) \tag{18b}$$

für

$$M_1(I_1) \leq M_1(I) < M_1(I_2) \text{ oder}$$

$$M_1(I_3) \leq M1(I) < M_1(I_4).$$

Der aktuelle Wert der Meßgröße I kann somit in einer vorteilhaften Ausführungsform auch direkt aus dem ersten Meßsignal $M_1$ und dem zweiten Meßsignal $M_2$ von der Signalverarbeitungseinheit 12 ermittelt werden, beispielsweise wieder mit Hilfe einer Wertetabelle oder auch rechnerisch mit Hilfe eines Prozessors. In diesem Fall ist das dritte Meßsignal $M_3$ gleich der identischen Funktion über **den** Meßbereich MR **hinweg**, also

$$M_3(I) = I. \tag{19}$$

Da es sich bei den beschriebenen Verfahren nicht um inkrementale Verfahren handelt, ist die Funktionszuverlässigkeit immer gegeben.

Für eine höhere Meßauflösung kann in einer besonderen Ausführungsform auch in Bereichen um die Stellen $I_n$, an denen die Meßauflösung $MA(M_2)$ des zweiten Meßsignals $M_2$ gleich Null ist, das erste Meßsignal $M_1$ als drittes Meßsignal $M_3$ verwendet werden. Dazu kann ein zusätzlicher Vergleich der Meßauflösungen $MA(M_1)$ des ersten Meßsignals $M_1$ und $MA(M_2)$ des zweiten Meßsignals $M_2$ durchgeführt werden und das erste Meßsignal $M_1$ als drittes Meßsignal $M_3$ herangezogen werden, solange $MA(M_2) < MA(M_1)$ gilt. Vorzugsweise werden die Bereiche, in denen diese Bedingung gilt, vorab ermittelt. Wenn die Bedingung nicht mehr erfüllt ist, wird das dritte Meßsignal $M_3$ wieder wie vorne beschrieben abgeleitet.

Das zweite Meßsignal $M_2$ kann auch eine andere periodische Funktion der Meßgröße I sein, beispielsweise eine lineare Kippfunktion (Sägezahn). Das erste Meßsignal $M_1$ kann auch eine lineare Funktion der Meßgröße I sein oder im Ausführungsbeispiel der FIG 2 durch eine lineare Funktion im Mittelpunkt $I_M$ angenähert werden (lineare Interpolation).

Die zuvor beschriebenen Ausführungsformen der Meßanordnung und des Meßverfahrens gemäß der Erfindung werden vorzugsweise zum Messen eines elektrischen Stromes I als Meßgröße mit Hilfe des Faraday-Effekts eingesetzt. Wie bereits beschrieben, werden bei einem polarimetrischen magnetooptischen Stromwandler im allgemeinen sinusförmige bzw. cosinusförmige Meßsignale gemäß einer der Gleichungen (2) oder (4) erzeugt, die dem in FIG 2 gezeigten Ausführungsbeispiel entsprechen.

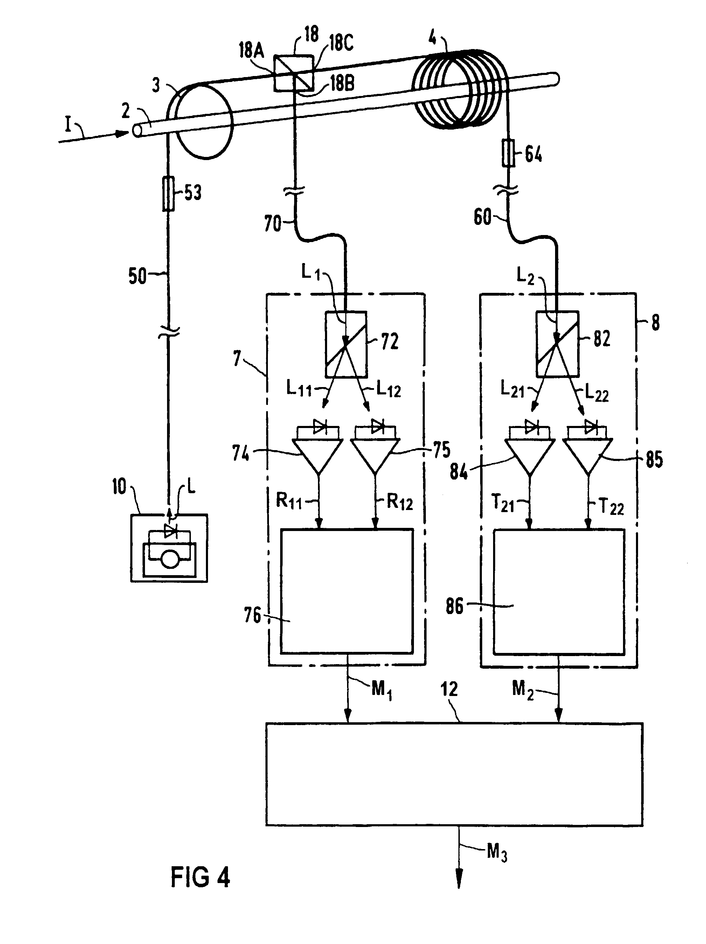

In FIG 3 ist ein Ausführungsbeispiel einer solchen Anordnung zum Messen eines elektrischen Stromes I in einem Stromleiter 2 dargestellt. Dem Stromleiter 2 sind zwei Faraday-Meßeinrichtungen 5 und 6 zugeordnet. Jede Faraday-Meßeinrichtung 5 und 6 weist jeweils ein den magnetooptischen Faraday-Effekt zeigendes Faraday-Element 3 und 4, eine Lichtquelle 9 bzw. 11 zum Senden eines linear polarisierten Lichtsignals $L_1$ bzw. $L_2$ in das Faraday-Element 3 bzw. 4 sowie eine Auswerteeinheit 7 bzw. 8 zum Auswerten einer Polarisationsdrehung (Faraday-Rotation) des linear polarisierten Lichtssignals $L_1$ bzw. $L_2$ nach wenigstens einmaligem Durchlaufen des Faraday-Elements 3 bzw. 4 infolge des von einem elektrischen Strom I im Stromleiter 2 erzeugten Magnetfelds auf. Die beiden Faraday-Elemente 3 und 4 umgeben vorzugsweise den Stromleiter 2, so daß durch die Faraday-Elemente 3 oder 4 laufendes Licht den Stromleiter 2 entlang eines praktisch geschlossenen Lichtweges wenigstens einmal umläuft.

Das erste Faraday-Element 3 und/oder das zweite Faraday-Element 4 können in einer Ausführungsform mit massiven, den Faraday-Effekt zeigenden Körpern, vorzugsweise aus Glas, gebildet sein. Es können ein oder auch mehrere Körper für jedes Faraday-Element 3 oder 4 vorgesehen sein. Ein einziger zusammenhängender Körper ist dann als im allgemeinen polygonaler Ringkörper ausgebildet. Solche massiven Körper, insbesondere ein Ringkörper, sind mechanisch robust und weisen praktisch keine zirkulare Doppelbrechung auf. In einer anderen Ausführungsform sind das erste Faraday-Element 3 und/oder das zweite Faraday-Element 4 mit einer bzw. jeweils einer Monomode-Lichtleitfaser gebildet, die vorzugsweise den Stromleiter 2 in Form einer Meßwicklung mit wenigstens einer Windung umgibt.

Die Polarisation des ersten Lichtsignals $L_1$ nach Durchlaufen des ersten Faraday-Elements 3 wird von der ersten Auswerteeinheit 7 der ersten Meßeinrichtung 5 für ein erstes Meßsignal $M_1$ für den elektrischen Strom I ausgewertet, während die Polarisation des zweiten Lichtsignals $L_2$ von der zweiten Auswerteeinheit 8 der zweiten Meßeinrichtung 6 für ein zweites Meßsignal $M_2$ für den elektrischen Strom I ausgewertet wird. Dabei kann für jede der beiden Auswerteeinheiten 7 und 8 jeweils eine einkanalige oder eine zweikanalige Polarisationsauswertung verwendet werden, so daß sich insbesondere sinusförmige Meßsignale $M_1$ und $M_2$ gemäß den Beziehungen (2) oder (4) ergeben. Auch können prinzipiell alle zur Unterdrückung oder Kompensation von linearer und/oder zirkularer Doppelbrechung, beispielsweise infolge von Temperaturänderungen oder Vibrationen, in den Faraday-Elementen 3 und 4 und den optischen Übertragungsstrecken bekannten zusätzlichen Maßnahmen vorgesehen werden, um Verfälschungen der Meßsignale zu korrrigieren.

Die beiden Meßsignale $M_1$ und $M_2$ werden wie in der Ausführungsform gemäß FIG 1 der Signalverarbeitungseinheit 12 zugeführt und weiterverarbeitet für ein dritte Meßsignal $M_3$ für den elektrischen Strom I im Stromleiter 2. Die Meßempfindlichkeit des ersten Faraday-Elements 3 ist kleiner als die Meßempfindlichkeit des zweiten Faraday-Elements 4 und so groß gewählt, daß das erste Meßsignal $M_1$ in einem vorgegebenen Strommeßbereich MR ein eindeutiges Maß für den Strom I ist. Die Meßempfindlichkeit des zweiten Faraday-Elements 4 ist dagegen so gewählt, daß die Periode $P_2$ des zweiten Meßsignals $M_2$ kleiner als die doppelte Länge des Strommeßbereichs MR ist. Das zweite Meßsignal $M_2$ ist somit keine eindeutige Funktion des Stromes I im Strommeßbereich MR. Zur Einstellung unterschiedlicher Meßempfindlichkeiten der beiden Faraday-Elemente 3 und 4 können beispielsweise Materialien mit unterschiedlichen Verdet-Konstanten für die beiden Faraday-Elemente 3 bzw. 4 verwendet werden oder auch Faraday-Elemente 3 und 4 mit unterschiedlichen Lichtweglängen entlang des vom Strom I erzeugten Magnetfeldes verwendet werden.

Vorzugsweise reicht der vorgegebene Strommeßbereich MR von einem Überstrommeßbereich, der typischerweise im Bereich zwischen 10 kA und wenigstens 100 kA liegt, bis zu einem Nennstrommeßbereich, der üblicherweise etwa um einen Faktor 10 bis 30 unterhalb des Überstrom-Meßbereichs liegt. Der Nennstrommeßbereich wird dabei vorzugsweise von einem eine halbe Periode $P_2$ langen Eindeutigkeitsbereich des zweiten Meßsignals $M_2$ überdeckt. Das mit dem Verfahren und der Anordnung gemäß der Erfindung hergeleitete dritte Meßsignal $M_3$ erlaubt eine Messung sowohl von Nennströmen für Meß- oder Zähleranwendungen als auch von Überströmen für Schutzzwecke mit der gleichen Meßauflösung.

Außer der anhand von FIG 3 beschriebenen Ausführungsform mit zwei getrennten Meßeinrichtungen 5 und 6 sind auch Ausführungsforemen möglich, bei denen die beiden Farday-Elemente 3 und 4 über optische Verbindungsmittel optisch in Reihe geschaltet werden und ein erstes linear polarisiertes Lichtsignal $L_1$ nur das erste Faraday-Element 3 sowie ein zweites linear polarisiertes Lichtsignal $L_2$ das erste Faraday-Element 3 und das zweite Faraday-Element 4 durchlaufen. Solche Ausführungsformen sind in den älteren, nicht-vorveröffentlichten deutschen Patentanmeldungen P 44 29 909.5 und P 44 31 615.1 offenbart. Die FIG 4 bis 6 zeigen Ausführungsbeispiele mit derart in Reihe geschalteten Faraday-Elementen 3 und 4.

In der Ausführungsform gemäß FIG 4 sind das erste Faraday-Element 3 und das zweite Faraday-Element 4 über einen Dreitor-Koppler 18 als optische Verbindungsmittel optisch in Reihe geschaltet. Sowohl für das erste Faraday-Element 3 als auch für das zweite Faraday-Element 4 ist jeweils eine optische Faser vorgesehen, die den Stromleiter 2 in Form einer Meßwicklung umgibt. Vorzugsweise sind getemperte optische Fasern (annealed fibres) vorgesehen, die sich durch niedrige lineare Doppelbrechung und praktisch vernachlässigbare zirkulare Doppelbrechung auszeichnen. Zur Anpassung der Strommeßbereiche kann in dieser Ausführungsform neben der Wahl unterschiedlicher Materialien für die beiden Faraday-Elemente 3 und 4 auch die Zahl der Windungen der Meßwicklungen variiert werden. Die Meßwicklung des zweites Faraday-Elements 4 weist dabei vorzugsweise mehr Windungen auf als die Wicklung des ersten Faraday-Elements 3. Eine Sendeeinheit 10 erzeugt linear polarisiertes Meßlicht L, das vorzugsweise über einen polarisationserhaltenden Lichtwellenleiter 50 in das erste Faraday-Element 3 eingekoppelt wird. Als Sendeeinheit 10 kann beispielsweise eine Laserdiode oder auch eine Lichtquelle (z.B. LED) mit nachgeschaltetem Polarisator vorgesehen sein. Als polarisationserhaltender Lichtwellenleiter 50 kann eine niedrigdoppelbrechende Lichtfaser (LoBi-Fibre) vorgesehen sein. Ein Spleiß 53 verbindet vorzugsweise den Lichtwellenleiter 50 mit der Meßwicklung des ersten Faraday-Elements 3. Der Dreitor-Koppler 18 ist derart ausgebildet, daß ein erster Teil des von der Sendeeinheit 10 in das erste Faraday-Element 3 eingekoppelten und durch das erste Faraday-Element 3 gelaufenen Meßlichts L als erstes Lichtsignal $L_1$ in die erste Auswerteeinheit 7 und ein zweiter Teil des durch das erste Faraday-Element 3 gelaufenen Meßlichts L als zweites Lichtsignal $L_2$ in das zweite Faraday-Element 4 eingekoppelt werden. Als Dreitor-Koppler 18 können ein strahlteilender, teildurchlässiger Spiegel, der unter einem Winkel von im allgemeinen 45° zur Strahlrichtung des auftreffenden Meßlichts L angeordnet ist, beispielsweise ein strahlteilender Spleiß, oder auch ein Y-Koppler, insbesondere ein Faserkoppler, vorgesehen sein. Ein erstes Tor 18A des Dreitor-Kopplers 18 ist mit dem ersten Faraday-Element 3, ein zweites Tor 18B mit der ersten Auswerteeinheit 7 und ein drittes Tor 18C mit dem zweiten Faraday-Element 4 optisch verbunden. Zum Übertragen des ersten Lichtsignals $L_1$ vom Dreitor-Koppler 18 zur ersten Auswerteeinheit 7 ist vorzugsweise ein polarisationserhaltender Lichtwellenleiter 70 vorgesehen. Das zweite Lichtsignal $L_2$ durchläuft das zweite Faraday-Element 4 nur einmal und wird dann unmittelbar in die zweite Auswerteeinheit 8 eingekoppelt, vorzugsweise ebenfalls über einen polarisationserhaltenden Lichtwellenleiter 60, der über einen Spleiß 64 mit der Meßwicklung des zweiten Faraday-Elements 4 verbunden sein und/oder als LoBi-Fibre ausgebildet sein kann. Das zweite Faraday-Element 4 wird somit bezüglich des zweiten Teils $L_2$ des Meßlichts L im Transmissionsmodus betrieben.

Die erste Auswerteeinheit 7 wertet die Faraday-Drehung der Polarisationsebene des ersten Lichtsignals $L_1$ für ein erstes Meßsignal $M_1$ aus, das an einem Ausgang der ersten Auswerteeinheit 7 abgegriffen werden kann. Damit wird das erste Faraday-Element 3 im Transmissionsmodus betrieben. Die zweite Auswerteeinheit 8 wertet die Faraday-Drehung der Polarisationsebene des zweiten Lichtsignals $L_2$ für ein zweites Meßsignal $M_2$ aus, das an einem Ausgang der zweiten Auswerteeinheit 8 abgegriffen werden kann. Die gesamte Faraday-Drehung der Polarisationsebene des zweiten Lichtsignals $L_2$ setzt sich dabei aus einem ersten, in dem ersten Faraday-Element 3 erfolgten ersten Faraday-Drehwinkelanteil und einem in dem zweiten Faraday-Element 4 bewirkten, zweiten Faraday-Drehwinkelanteil zusammen. Wenn die Faraday-Drehung in beiden Faraday-Elementen 3 und 4 in der gleichen Richtung erfolgte, entsprechend einem gleichen Umlaufsinn des transmittierten Lichts in erstem Faraday-Element 3 und zweitem Faraday-Element 4 relativ zur Stromrichtung im Stromleiter 2, dann ist der gesamte Drehwinkel gleich der Summe der beiden einzelnen Drehwinkel. Bei entgegengesetzter Drehrichtung entspricht der resultierende Drehwinkel dagegen der Differenz der beiden einzelnen Drehwinkel.

Die in FIG 4 gezeigten vorteilhaften Ausführungsformen der beiden Auswerteeinheiten 7 und 8 führen jeweils eine zweikanalige Polarisationsanalyse des zugehörigen Lichtsignals $L_1$ bzw. $L_2$ durch. In der ersten Auswerteeinheit 7 sind mit dem Tor 18B des Dreitor-Kopplers 18 über den polarisationserhaltenden Lichtleiter 70 optisch gekoppelte Mittel 72 zum Aufteilen des erstes Lichtsignal $L_1$ in zwei linear polarisierte Lichtteilsignale $L_{11}$ und $L_{12}$ mit unterschiedlichen Polarisationsebenen vorgesehen, beispielsweise ein polarisierender Strahlteiler, vorzugsweise ein Wollaston-Prisma, oder auch ein Strahlteiler und zwei optisch nachgeschaltete, um einen vorgegebenen Winkel gekreuzte Analysatoren. Als polarisationserhaltender Lichtwellenleiter 70 kann insbesondere eine optische Faser mit hoher linearer Doppelbrechung (HiBi-Faser) vorgesehen werden, deren Eigenachsen der linearen Doppelbrechung auf die Eigenachsen des Wollaston-Prismas 72 justiert sind. Ferner enthält die Auswerteeinheit 7 photoelektrische Wandler 74 und 75 zum Umwandeln der Lichtteilsignale $L_{11}$ und $L_{12}$ in jeweils ein elektrisches Signal $R_{11}$ bzw. $R_{12}$ als Maß für die Intensität des jeweiligen Lichtteilsignals $L_{11}$ bzw. $L_{12}$ sowie elektronische Mittel 76 zum Ableiten des ersten Meßsignals $M_1$ aus diesen beiden elektrischen Signalen $R_{11}$ und $R_{12}$. Vorzugsweise ermitteln die elektronischen Mittel 76 als erstes Meßsignal $M_1$ ein Quotientensignal

$$M_1 = (R_{11}-R_{12})/R_{11}+R_{12}) \qquad (20)$$

aus der Differenz $R_{11}-R_{12}$ und der Summe $R_{11}+R_{12}$ der beiden elektrischen Signale $R_{11}$ und $R_{12}$. Dieses Quotientensignal ist von Intensitätsschwankungen der Sendeeinheit 10 oder in den Übertragungsstrecken für das Meßlicht L und das erste Lichtsignal $L_1$ weitgehend befreit und es gilt im allgemeinen:

$$M_1 = \sin(2 \cdot N_s \cdot V_s \cdot \alpha + \zeta) \qquad (21)$$

mit dem Faraday-Drehwinkel $\alpha$ des ersten Lichtsignals $L_1$, der Anzahl $N_s$ der Windungen des ersten Faraday-Elements 3 und der Verdet-Konstanten $V_S$ des Materials des ersten Faraday-Elements 3 sowie dem konstanten Off-set-Winkel $\zeta$. Typischerweise ist $N_s$ zwischen 1 und 3. Die Lichtteilsignale $L_{11}$ und $L_{12}$ können in einer Freistrahlanordnung oder auch über Lichtleitfasern zu den Wandlern 74 und 75 übertragen werden. Die Ausgänge der photoelektrischen Wandler 74 und 75 sind jeweils mit einem Eingang der elektronischen Mittel 76 elektrisch verbunden.

Die zweite Auswerteeinheit 8 ist analog zur ersten Auswerteeinheit 7 aufgebaut. Es sind mit dem zweiten Faraday-Element 4 über einen polarisationserhaltenden Lichtwellenleiter 60 optisch verbundene Mittel 82 zum Aufteilen des linear polarisierten, durch das zweite Faraday-Element 4 transmittierten Lichtanteils L2 in zwei linear polarisierte Lichtteilsignale $L_{21}$ und $L_{22}$ mit unterschiedlichen Polarisationsebenen vorgesehen, vorzugsweise ein Wollaston-Prisma. Der Lichtwellenleiter 60 ist mit der Faser des zweiten Faraday-Elements 4 über einen Spleiß 64 verbunden. Als polarisationserhaltender Lichtwellenleiter 60 kann insbesondere eine optische Faser mit hoher linearer Doppelbrechung (HiBi-Faser) vorgesehen werden, deren Eigenachsen der linearen Doppelbrechung auf die Eigenachsen des Wollaston-Prismas 82 justiert sind. Ferner enthält die zweite Auswerteeinheit photoelektrische Wandler 84 und 85 zum Umwandeln dieser Lichtteilsignale $L_{21}$ und $L_{22}$ in jeweils ein elektrisches Signal $T_{21}$ bzw. $T_{22}$ als Maß für die Intensität des jeweiligen Lichtteilsignals $L_{21}$ bzw. $L_{22}$ und elektronische Mittel 86 zum Ableiten des zweiten Meßsignals $M_2$ aus den beiden elektrischen Signale $T_{21}$ und $T_{22}$. Vorzugsweise wird von den elektronischen Mitteln 86 als zweites Meßsignal $M_2$ ein intensitätsnormiertes Quotientensignal

$$M_2 = (T_{21}-T_{22})/(T_{21}+T_{22}) \qquad (22)$$

aus der Differenz $T_{21}-T_{22}$ und der Summe $T_{21}+T_{22}$ der beiden elektrischen Signale $T_{21}$ und $T_{22}$ hergeleitet. Dieses zweite Meßsignal $M_2$ hängt vom Faraday-Gesamtdrehwinkel $\beta$ des zweiten Lichtsignals $L_2$ in folgender Weise ab:

$$M_2 = \sin(2 \cdot (N_s \cdot V_s + N_M \cdot V_M) \cdot \beta + \tau) \qquad (23)$$

mit der Windungszahl $N_M$ und der Verdet-Konstanten $V_M$ des zweiten Faraday-Elements 4 und einem konstanten Off-set-Winkel $\tau$. Die Windungszahl $N_M$ des zweiten Faraday-Elements 4 wird im allgemeinen zwischen 10 und 50 gewählt.

Die elektronischen Mittel 76 und/oder 86 enthalten in einer bevorzugten Ausführungsform einen Analog-/Digital-Wandler zum Digitalisieren der beiden Signale $R_{11}$ und $R_{12}$ der Wandler 74 und 75 bzw. $T_{21}$ und $T_{22}$ der Wandler 84 und 85 und eine nachgeschaltete digitale Recheneinheit zum Berechnen des ersten Meßsignals $M_1$ bzw. des zweiten Meßsignals $M_2$.

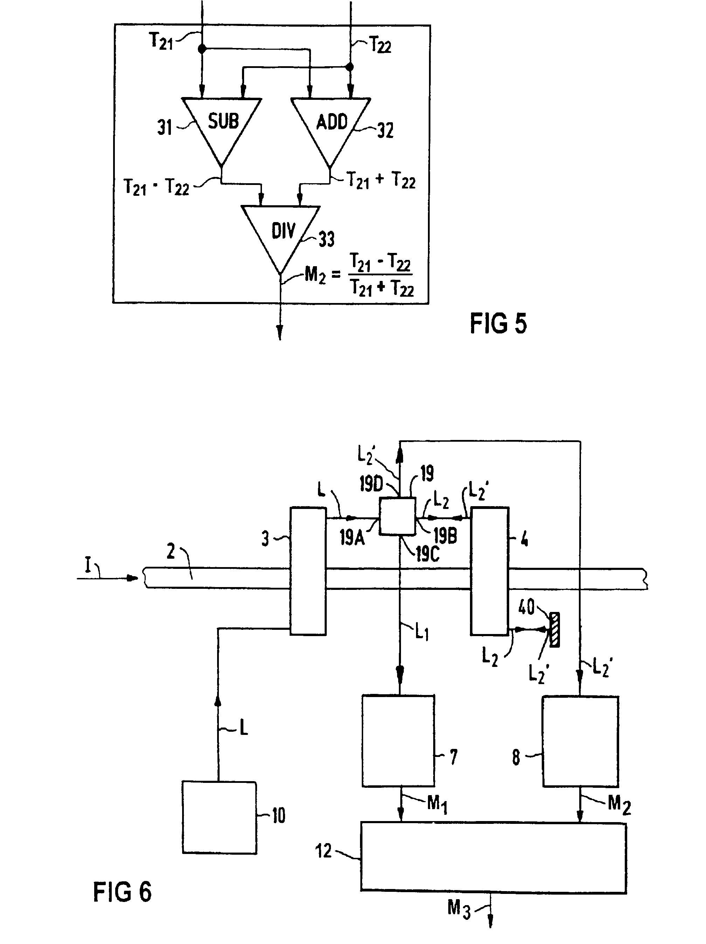

In einer anderen, in FIG 5 dargestellten Ausführungsform enthalten die elektronischen Mittel 86 analoge Rechenkomponenten. Dadurch kann eine schnellere Signalverarbeitung erreicht werden. Es sind ein Subtrahierer 31 und ein Addierer 32 vorgesehen, an deren Eingängen jeweils die beiden elektrischen Signale $T_{21}$ und $T_{22}$ der nicht dargestellten Wandler 84 und 85 anliegen. Die Ausgänge des Subtrahierers 31 und des Addierers 32 sind jeweils mit einem Eingang eines Dividierers 33 verbunden. Der Dividierer 33 bildet aus dem Differenzsignal $T_{21}-T_{22}$ am Ausgang des Sunbtrahierers 31 und dem Summensignal $T_{21}+T_{22}$ am Ausgang des Addierers 32 das Quotientensignale $(T_{21}-T_{22})/(T_{21}+T_{22})$ als zweites Meßsignal $M_2$. Eine entsprechende Schaltung kann auch für die elektronischen Mittel 76 der ersten Auswqerteeinheit 7 vorgesehen sein.

Die FIG 6 zeigt eine weitere Ausführungsform der Meßanordnung. Das erste Faraday-Element 3 und das zweite Faraday-Element 4 sind über einen optischen Viertor-Koppler 19 mit vier Toren 19A bis 19D als optische Verbindungsmittel optisch in Reihe geschaltet. Die zweite Auswerteeinheit 8 ist mit dem Tor 19D des Viertor-Kopplers 19 optisch verbunden. Dem zweiten Faraday-Element 4 sind lichtreflektierende Mittel 40, beispielsweise ein Spiegel, zugeordnet, die das zweite Lichtsignal $L_2$ nach erstmaligem Durchlaufen des zweiten Faraday-Elements 4 in das zweite Faraday-Element 4 zurückreflektieren. Das zurückreflektierte zweite Lichtsignal $L_2'$ durchläuft das zweite Faraday-Element 4 in umgekehrter Richtung ein zweites Mal und wird über den Viertor-Koppler 19 dann der zweiten Auswerteeinheit 8 zugeführt. Das mit dem zweiten Faraday-Element 4 verbundene Tor 19B und das mit der zweiten Auswerteeinheit 8 verbundene Tor 19D des Viertor-Kopplers 19 sind dazu optisch miteinander gekoppelt. Ebenfalls optisch miteinander gekoppelt sind das mit dem ersten Faraday-Element 3 verbundene Tor 19A und das mit der ersten Auswerteeinheit 7 verbundene Tor 19C des Viertor-Kopplers 19. Als Viertor-Koppler 19 kann beispielsweise ein Strahlteiler mit einem schräg zur Lichtausbreitungsrichtung angeordneten teildurchlässigen Spiegel oder ein faseroptischer Koppler vorgesehen sein. Das zweite Faraday-Element 4 wird in dieser Ausführungsform gemäß FIG 6 im Reflexionsmodus betrieben. Das von der zweiten Auswerteeinheit 8 ausgewertete zweites Lichtsignal $L_2'$ weist eine Faraday-Rotation seiner Polarisationsebene auf, die sich aus der Faraday-Drehung bei einem Durchlauf des ersten Faraday-Elements 3 und der doppelten Faraday-Drehung bei einem Durchlauf des zweiten Faraday-Element 4 zusammensetzt.

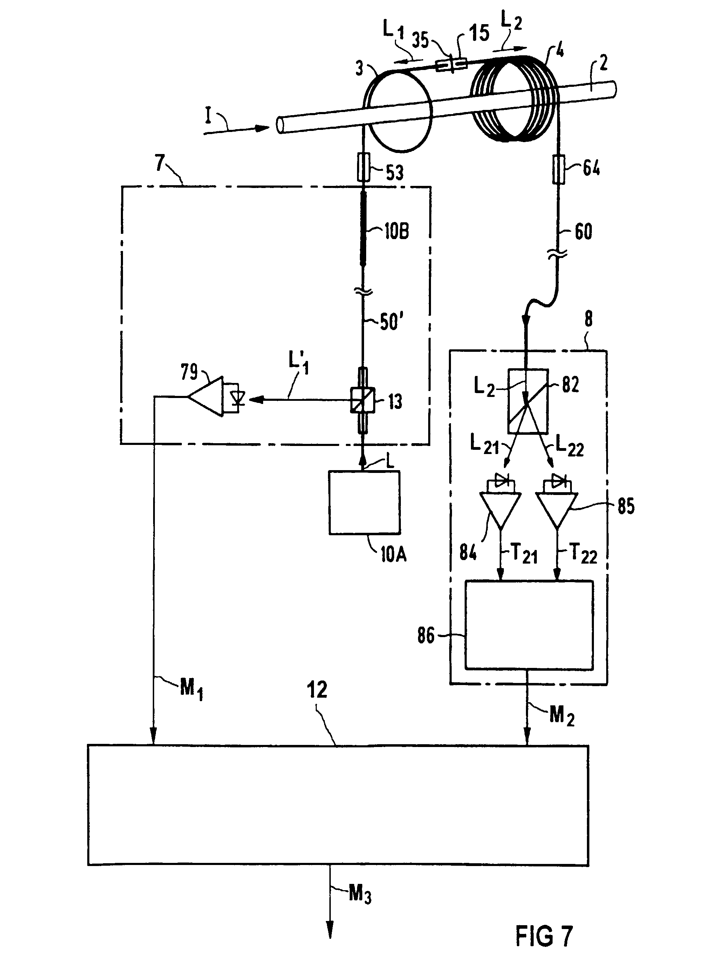

In der Ausführungsform gemäß FIG 7 wird das erste Faraday-Element 3 in einer Reflexionsanordnung betrieben. Ein optischer Koppler 13 verbindet das erste Faraday-Element 3 sowohl mit der Sendeeinheit 10 zum Senden von linear polarisiertem Meßlicht L als auch mit der ersten Auswerteeinheit 7. Dieser Koppler 13 kann ein Y-Faserkoppler oder auch ein mit einem teildurchlässigen Spiegel gebildeter Strahlteiler sein. Die optischen Verbindungsmittel 15 zum optischen Koppeln der beiden Faraday-Elemente 3 und 4 sind nun derart ausgebildet, daß ein Teil des durch das erste Faraday-Element 3 gelaufenen Meßlichts L als erstes Lichtsignal $L_1$ in das erste Faraday-Element 3 zurückreflektiert wird und ein anderer Teil als zweites Lichtsignal $L_2$ durchgelassen und in das zweite Faraday-Element 4 eingekoppelt wird. Dazu enthalten die optischen Verbindungsmittel 15 vorzugsweise einen teildurchlässigen Spiegel 35, der im wesentlichen senkrecht zur Strahlrichtung des auftreffenden Meßlichts L angeordnet ist. Es können allerdings auch ein Strahlteiler mit einem unter einem Winkel, beispielsweise 45°, zur Strahlrichtung des einfallenden Meßlichts L gerichteten teildurchlässigen Spiegel und ein im Strahlengang des an diesem teildurchlässigen Spiegel reflektierten Meßlichtanteils angeordneter weiterer Spiegel zum Zurückreflektieren dieses Meßlichtanteils zum teildurchlässigen Spiegel vorgesehen sein. Das von den optischen Verbindungsmitteln 15 zurückreflektierte erste Lichtsignal $L_1$ durchläuft das erste Faraday-Element 3 in umgekehrter Richtung ein zweites Mal und wird über den optischen Koppler 13 der ersten Auswerteeinheit 7 zugeführt. Das erste Lichtsignal $L_1$ erfährt wegen der Nicht-Reziprokität des Faraday-Effekts eine Faraday-Drehung, die doppelt so groß ist wie bei nur einmaligem Durchlaufen des Faraday-Elements 3. Effekte einer möglichen zirkularen Doppelbrechung im ersten Faraday-Elements 3 heben sich dagegen wegen ihrer reziproken Eigenschaft gerade heraus. Die Auswerteeinheit 7 leitet aus dem ersten Lichtsignal $L_1$ das erstes Meßsignal $M_1$ ab. Das von den optischen Verbindungsmitteln 15 durchgelassene zweite Lichtsignal $L_2$ durchläuft dagegen nach dem ersten Faraday-Element 3 auch das zweite Faraday-Element 4 und wird nach dem Durchlaufen des zweiten Faraday-Element 4 der zweiten Auswerteeinheit 8 zugeführt. Das an der Auswerteeinheit 8 ankommende zweite Lichtsignal $L_2$ weist eine Polarisationsebene auf, die sowohl in dem ersten Faraday-Element 3 um einen ersten Faraday-Drehwinkel als auch in dem zweiten Faraday-Element 4 um einen zweiten Faraday-Drehwinkel gedreht wurde. In der Auswerteeinheit 8 wird der resultierende Gesamtdrehwinkel des zweiten Lichtsignals $L_2$ für ein zweites Meßsignal $M_2$ ausgewertet.

Sowohl für das erste Faraday-Element 3 als auch für das zweite Faraday-Element 4 sind in der dargestellten Ausführungsform jeweils eine den Stromleiter 2 umgebende Faserspule aus einer optischen Monomode-Faser vorgesehen. Die optischen Verbindungsmittel 15 sind dann mit einer halbdurchlässigen durch Sputtern oder chemische Ablagerung auf das Faserende vorzugsweise des ersten Faraday-Elements 3 aufgebrachten Beschichtung als Spiegel 35 und mechanischen Verbindungsmitteln zum Verbinden des mit dem Spiegel versehenen Faserendes mit dem benachbarten Faserende des anderen Faraday-Elements ausgebildet. Die mechanischen Verbindungsmittel können eine lösbare Steckverbindung oder auch ein unlösbarer Spleiß, beispielsweise ein Kapillarröhrchen der Firma Nippon Electric Glass, sein.

Die zweite Auswerteeinheit 8 ist analog aufgebaut wie in FIG 4. Die erste Auswerteeinheit 7 enthält dagegen in der dargestellten Ausführungsform polarisierende Mittel 10B, die optisch zwischen das erste Faraday-Element 3 und den Koppler 13 geschaltet sind, und einen Photodetektor 79, der optisch mit dem Koppler 13 gekoppelt ist. Es ist eine Lichtquelle 10A zum Senden von Licht L vorgesehen, die optisch mit dem Koppler 13 gekoppelt ist. Der Koppler 13 kann über eine optische Faser 50' mit den polarisierenden Mitteln 10B verbunden sein. Diese Faser 50' kann in dieser Ausführungsform eine einfache Telekommunikationsfaser sein ohne polarisationserhaltende Eigenschaften, da die polarisierenden Mittel 10B das Licht L erst unmittelbar vor seinem Eintritt in die Serienschaltung der beiden Faraday-Elemente 3 und 4 am Eingang des ersten Faraday-Elements 3 linear polarisieren. Daher kann als Lichtquelle 10A auch eine nicht polarisierende, einfache Lichtquelle vorgesehen sein. Die polarisierenden Mittel 10B und die Lichtquelle 10A bilden gemeinsam die Sendeeinheit 10 zum Einkoppeln linear polarisierten Meßlichts L in das erste Faraday-Element 3. Für das von den teilreflektierenden Verbindungsmitteln 15 reflektierten, in seiner Polarisationsebene gedrehte erste Lichtsignal $L_1$ sind die polarisierenden Mittel 10B zugleich als Analysator vorgesehen. Der Analysator läßt nur den auf seine eingestellte Polarisationsachse projizierten Anteil $L_1'$ des ersten Lichtsignals $L_1$ durch. Die durch den Analysator hindurchgetretene Lichtkomponente $L_1'$ des ersten Lichtsignals $L_1$ wird über den Koppler 13 dem Photodetektor 79 zugeführt und dort in ein elektrisches Signal als erstes Meßsignal $M_1$ umgewandelt. Dieses erste Meßsignal $M_1$ ist proportional zur Lichtintensität der Lichtkomponente $L_1'$. Es gilt deshalb

$$M_1 = K \cos^2 (0{,}5 \cdot N_S \cdot V_S \cdot \alpha) \qquad\qquad (24)$$

mit dem Faraday-Drehwinkel $\alpha$ des ersten Lichtsignals $L_1$ und einem Proportionalitätsfaktor K.

Zusätzlich kann wegen der für Nennströme geforderten hohen Meßauflösung ein Temperatur- und/oder Vibrationskompensationsverfahren durchgeführt werden.

Für die Auswertung der Faraday-Drehwinkel in der ersten Auswerteeinheit 7 sowie in der zweiten Auswerteeinheit 8 können prinzipiell alle analogen und digitalen Auswerteverfahren zum Erfassen des Polarisationszustandes von linear polarisiertem Licht verwendet werden. Insbesondere können die Ausführungsformen der Auswerteeinheiten 7 und 8 gemäß den FIG 4, 5 und 7 beliebig miteinander kombiniert werden. Vorzugsweise werden beide Lichtsignale $L_1$ und $L_2$ mit einer zweikanaligen Polarisationsanalyse ausgewertet. Es können aber auch jeweils eine einkanalige Auswertung für jedes Lichtsignal $L_1$ und $L_2$ vorgesehen sein. Die erhaltenen Meßsignale $M_1$ und $M_2$ sind dann von der sinusförmigen Gestalt wie in der Beziehung (23) oder (24) und erfüllen somit bei entsprechend gewählten Meßempfindlichkeiten $N_S \cdot V_S$ des ersten Faraday-Elements 3 und $N_M \cdot V_M$ des zweiten Faraday-Elements 4 die Voraussetzungen für das Ableiten des dritten Meßsignals $M_3$ gemäß einer der vorbeschriebenen Ausführungsformen.

Die optische Kopplung der verschiedenen optischen Komponenten der Meßanordnung wird vorzugsweise durch Kollimatorlinsen (Grin lenses) zum Bündeln des Lichts unterstützt.

In einer besonderen, nicht dargestellten Ausführungsform können auch mehrere linear polarisierte Meßlichtsignale verschiedener und in der Regel nahe beieinanderliegender Wellenlängen in Verbindung mit wellenlängenempfindlichen optischen Verbindungsmitteln 15, 18 oder 19 verwendet werden. Damit kann ein Übersprechen zwischen Schutz- und Meßkanal vermieden werden.

**Patentansprüche**

1. Verfahren zum Messen einer Meßgröße (I) aus einem vorgegebenen Meßbereich (MR), bei dem

   a) ein erstes Meßsignal ($M_1$) für die Meßgröße (I) abgeleitet wird, das eine über **den** vorgegebenen Meßbereich (MR) **hinweg** eindeutige Funktion der Meßgröße (I) ist,
   b) ein zweites Meßsignal ($M_2$) für die Meßgröße (I) abgeleitet wird, das zumindest über **den** vorgegebenen Meßbereich (MR) **hinweg** eine periodische Funktion der Meßgröße (I) ist, mit einer Periode ($P_2$), die kleiner ist als die doppelte Intervallänge (|MR|) des Meßbereichs (MR), und
   c) aus dem ersten Meßsignal ($M_1$) und dem zweiten Meßsignal ($M_2$) ein drittes Meßsignal ($M_3$) für die Meßgröße (I) abgeleitet wird, das im vorgegebenen Meßbereich (MR) eine eindeutige Funktion der Meßgröße (I) ist und wenigstens die gleiche Meßauflösung wie das zweite Meßsignal ($M_2$) aufweist.

2. Verfahren nach Anspruch 1, bei dem auch das erste Meßsignal ($M_1$) wenigstens über **den** vorgegebenen Meßbereich (MR) **hinweg** eine periodische Funktion der Meßgröße (I) ist.

3. Verfahren nach Anspruch 1 oder Anspruch 2, bei dem mit Hilfe des ersten Meßsignals ($M_1$) der Meßbereich (MR) in Eindeutigkeitsbereiche unterteilt wird, über **die hinweg** das zweite Meßsignal ($M_2$) eine eindeutige Funktion der Meßgröße (I) ist, und **bei dem** aus den Zweigen des zweiten Meßsignals ($M_2$) **in** diesen Eindeutigkeitsbereichen das dritte Meßsignal ($M_3$) zusammengesetzt wird.

4. Verfahren nach einem der vorhergehenden Ansprüche, bei dem das dritte Meßsignal ($M_3$) aus dem ersten Meßsignal ($M_1$) und dem zweiten Meßsignal ($M_2$) mit Hilfe einer vorab ermittelten Wertetabelle abgeleitet wird.

5. Verfahren nach einem der Ansprüche 1 bis 3, bei dem das dritte Meßsignal ($M_3$) aus dem ersten Meßsignal ($M_1$)

und dem zweiten Meßsignal ($M_2$) berechnet wird.

6.  Verfahren nach einem der vorhergehenden Ansprüche zum Messen eines elektrischen Stromes (I) aus einem vorgegebenen Strommeßbereich (MR) in einem Stromleiter (2) mit wenigstens zwei den Stromleiter (2) umgebenden Faraday-Elementen (3,4), bei dem

    a) ein erstes linear polarisiertes Lichtsignal ($L_1$) ein erstes der beiden Faraday-Elemente (3) wenigstens einmal durchläuft und aus einer Drehung der Polarisationsebene dieses ersten Lichtsignals ($L_1$) das erste Meßsignal ($M_1$) für den Strom (I) abgeleitet wird,

    b) ein zweites linear polarisiertes Lichtsignal ($L_2$) wenigstens ein zweites der beiden Faraday-Elemente (4) wenigstens einmal durchläuft und aus einer Drehung der Polarisationsebene dieses zweiten Lichtsignals ($L_2$) das zweite Meßsignal ($M_2$) für den Strom (I) abgeleitet wird.

7.  Verfahren nach Anspruch 6, bei dem das zweite linear polarisierte Lichtsignal ($L_2$) sowohl das erste Faraday-Element (3) als auch das zweite Faraday-Element (4) jeweils wenigstens einmal durchläuft.

8.  Anordnung zum Messen einer Meßgröße (I) aus einem vorgegebenen Meßbereich (MR) mit

    a) einer ersten Meßeinrichtung (5) zum Erzeugen eines ersten Meßsignals ($M_1$), das eine über **den** vorgegebenen Meßbereich (MR) **hinweg** eindeutige Funktion der Meßgröße (I) ist,

    b) einer zweiten Meßeinrichtung (6) zum Erzeugen eines zweiten Meßsignals ($M_2$), das eine periodische Funktion der Meßgröße (I) ist mit einer Periode ($P_2$), die kleiner ist als die doppelte Intervallänge (|MR|) des Meßbereichs (MR), und

    c) einer mit den beiden Meßeinrichtungen (5,6) verbundenen Signalverarbeitungseinheit (12), die aus dem ersten Meßsignal ($M_1$) und dem zweiten Meßsignal ($M_2$) ein drittes Meßsignal ($M_3$) ableitet, das im vorgegebenen Meßbereich (MR) eine eindeutige Funktion der Meßgröße (I) ist und wenigstens die gleiche Meßauflösung wie das zweite Meßsignal ($M_2$) aufweist.

9.  Anordnung nach Anspruch 8, bei der **auch** das von der **ersten** Meßeinrichtung (**5**) erzeugte **erste** Meßsignal ($M_1$) **wenigstens über den vorgegebenen Meßbereich (MR) hinweg** eine periodische Funktion der Meßgröße (I) ist.

10. Anordnung nach Anspruch 8 oder Anspruch 9, bei der die Signalverarbeitungseinheit (12) mit Hilfe des ersten Meßsignals ($M_1$) den Meßbereich (MR) in Eindeutigkeitsbereiche unterteilt, über **die hinweg** das zweite Meßsignal ($M_2$) eine eindeutige Funktion der Meßgröße (I) ist, und aus den Zweigen des zweiten Meßsignals ($M_2$) **in** diesen Eindeutigkeitsbereichen das dritte Meßsignal ($M_3$) zusammensetzt.

11. Anordnung nach einem der Ansprüche 8 bis 10, bei der die Signalverarbeitungseinheit (12) zum Ableiten des dritten Meßsignals ($M_3$) aus dem ersten Meßsignal ($M_1$) und dem zweiten Meßsignal ($M_2$) eine vorab ermittelte Wertetabelle enthält.

12. Anordnung nach einem der Ansprüche 8 bis 10, bei der die Signalverarbeitungseinheit (12) arithmetische Mittel zum Berechnen des dritten Meßsignals ($M_3$) aus dem ersten Meßsignal ($M_1$) und dem zweiten Meßsignal ($M_2$) enthält.

13. Anordnung nach einem der Ansprüche 8 bis 12 zum Messen eines elektrischen Stromes (I) aus einem vorgegebenen Strommeßbereich (MR) in einem Stromleiter (2), bei der

    a) die erste Meßeinrichtung (5) ein erstes, den Stromleiter (2) umgebendes Faraday-Element (3) und eine erste Auswerteeinheit (7) enthält, die aus einer Drehung der Polarisationsebene eines ersten linear polarisierten Lichtsignals ($L_1$) nach dessen wenigstens einmaligem Durchlaufen des ersten Faraday-Elements (3) das erste Meßsignal ($M_1$) für den Strom (I) ableitet,

    b) die zweite Meßeinrichtung (6) wenigstens ein zweites, den Stromleiter (2) umgebendes Faraday-Element (4) und eine zweite Auswerteeinheit (8) enthält, die aus einer Drehung der Polarisationsebene eines zweiten linear polarisierten Lichtsignals ($L_2$) nach dessen wenigstens einmaligem Durchlaufen wenigstens des zweiten Faraday-Elements (4) das zweite Meßsignal ($M_2$) für den Strom (I) ableitet.

14. Anordnung nach Anspruch 13, bei der

a) das erste Faraday-Element (3) gemeinsamer Bestandteil sowohl der ersten Meßeinrichtung (5) als auch der zweiten Meßeinrichtung (6) ist,

b) die beiden Faraday-Elemente (3,4) über optische Verbindungsmittel (14,15,16) optisch in Reihe geschaltet sind und

c) das zweite Lichtsignal ($L_2$) das erste Faraday-Element (3) und das zweite Faraday-Element (4) jeweils wenigstens einmal durchläuft.

**Claims**

1. Method for measuring a measured variable (I) from a prescribed measuring range (MR), in which

   a) there is derived for the measured variable (I) a first measuring signal ($M_1$) which is a unique function of the measured variable (I) over the prescribed measuring range (MR),

   b) there is derived for the measured variable (I) a second measuring signal ($M_2$) which, at least over the prescribed measuring range (MR), is a periodic function of the measured variable (I), with a period ($P_2$) which is shorter than twice the interval length (|MR|) of the measuring range (MR), and

   c) there is derived for the measured variable (I) from the first measuring signal ($M_1$) and the second measuring signal ($M_2$) a third measuring signal ($M_3$) which is a unique function of the measured variable (I) in the prescribed measuring range (MR) and has at least the same measuring resolution as the second measuring signal ($M_2$).

2. Method according to Claim 1, in which the first measuring signal ($M_1$) is also a periodic function of the measured variable (I), at least over the prescribed measuring range (MR).

3. Method according to Claim 1 or Claim 2, in which the measuring range (MR) is subdivided with the aid of the first measuring signal ($M_1$) into uniqueness ranges over which the second measuring signal ($M_2$) is a unique function of the measured variable (I), and in which the third measuring signal ($M_3$) is composed of the branches of the second measuring signal ($M_2$) in these uniqueness ranges.

4. Method according to one of the preceding claims, in which the third measuring signal ($M_3$) is derived from the first measuring signal ($M_1$) and the second measuring signal ($M_2$) with the aid of a previously determined table of values.

5. Method according to one of Claims 1 to 3, in which the third measuring signal ($M_3$) is calculated from the first measuring signal ($M_1$) and the second measuring signal ($M_2$).

6. Method according to one of the preceding claims for measuring an electric current (I) from a prescribed current measuring range (MR) in a conductor (2), having at least two Faraday elements (3, 4) surrounding the conductor (2), in which

   a) a first linearly polarized light signal (L1) traverses a first of the two Faraday elements (3) at least once, and the first measuring signal ($M_1$) for the current (I) is derived from a rotation of the polarization plane of this first light signal ($L_1$),

   b) a second linearly polarized light signal ($L_2$) traverses at least a second of the two Faraday elements (4) at least once, and the second measuring signal ($M_2$) for the current (I) is derived from a rotation of the polarization plane of this second light signal ($L_2$).

7. Method according to Claim 6, in which the second linearly polarized light signal ($L_2$) traverses both the first Faraday element (3) and the second Faraday element (4) at least once in each case.

8. Arrangement for measuring a measured variable (I) from a prescribed measuring range (MR), having

   a) a first measuring device (5) for generating a first measuring signal ($M_1$) which is a unique function of the measured variable (I) over the prescribed measuring range (MR),

   b) a second measuring device (6) for generating a second measuring signal ($M_2$) which is a periodic function of the measured variable (I) with a period ($P_2$) which is shorter than twice the interval length (|MR|) of the measuring range (MR), and

   c) a signal processing unit (12) which is connected to the two measuring devices (5, 6) and derives from the

first measuring signal ($M_1$) and the second measuring signal ($M_2$) a third measuring signal ($M_3$) which is a unique function of the measured variable (I) in the prescribed measuring range (MR) and has at least the same measuring resolution as the second measuring signal ($M_2$).

**9.** Arrangement according to Claim 8, in which the first measuring signal ($M_1$) generated by the first measuring device (5) is also a periodic function of the measured variable (I) at least over the prescribed measuring range (MR).

**10.** Arrangement according to Claim 8 or Claim 9, in which the signal processing unit (12) subdivides the measuring range (MR) with the aid of the first measuring signal ($M_1$) into uniqueness ranges over which the second measuring signal ($M_2$) is a unique function of the measured variable (I), and the third measuring signal ($M_3$) is composed of the branches of the second measuring signal ($M_2$) in these uniqueness ranges.

**11.** Arrangement according to one of Claims 8 to 10, in which the signal processing unit (12) contains a previously determined table of values for the purpose of deriving the third measuring signal ($M_3$) from the first measuring signal ($M_1$) and the second measuring signal ($M_2$).

**12.** Arrangement according to one of Claims 8 to 10, in which the signal processing unit (12) contains arithmetic means for calculating the third measuring signal ($M_3$) from the first measuring signal ($M_1$) and the second measuring signal ($M_2$).

**13.** Arrangement according to one of Claims 8 to 12 for measuring an electric current (I) from a prescribed current measuring range (MR) in a conductor (2), in which

a) the first measuring device (5) contains a first Faraday element (3) surrounding the conductor (2) and contains a first evaluation unit (7) which derives the first measuring signal ($M_1$) for the current (I) from a rotation of the polarization plane of a first linearly polarized light signal ($L_1$) after the latter has traversed the first Faraday element (3) at least once,
b) the second measuring device (6) contains at least a second Faraday element (4) surrounding the conductor (2) and contains a second evaluation unit (8) which derives the second measuring signal ($M_2$) for the current (I) from a rotation of the polarization plane of a second linearly polarized light signal ($L_2$) after the latter has traversed the second Faraday element (4) at least once.

**14.** Arrangement according to Claim 13, in which

a) the first Faraday element (3) is a common component both of the first measuring device (5) and of the second measuring device (6),
b) the two Faraday elements (3, 4) are connected optically in series via optical connecting means (14, 15, 16), and
c) the second light signal ($L_2$) traverses the first Faraday element (3) and the second Faraday element (4) at least once in each case.

**Revendications**

**1.** Procédé de mesure d'une grandeur (I) à mesurer dans un domaine (MR) de mesure prescrit, qui consiste

a) à déduire pour la grandeur (I) à mesurer un premier signal ($M_1$) de mesure, qui est une fonction univoque de la grandeur (I) a mesurer sur tout le domaine (MR) de mesure prescrit
b) à déduire pour la grandeur (I) à mesurer un deuxième signal ($M_2$) de mesure, qui est au moins sur tout le domaine (MR) de mesure prescrit une fonction périodique de la grandeur (I) à mesurer avec une période ($P_2$) qui est inférieure au double de la longueur (|MR|) de l'intervalle du domaine de mesure, et
c) à déduire du premier signal ($M_1$) de mesure et du deuxième signal ($M_2$) de mesure un troisième signal ($M_3$) de mesure de la grandeur (I) à mesurer qui, dans le domaine (MR) de mesure prescrit, est une fonction univoque de la grandeur (I) à mesurer et qui a au moins la même résolution de mesure que le deuxième signal ($M_2$) à mesurer.

**2.** Procédé suivant la revendication 1, dans lequel le premier signal ($M_1$) de mesure est aussi une fonction périodique de la grandeur (I) à mesurer au moins sur tout le domaine (MR) de mesure.

**3.** Procédé suivant la revendication 1 ou la revendication 2, qui consiste à subdiviser à l'aide du premier signal ($M_1$) de mesure le domaine (MR) de mesure en domaines d'univalence sur tous lesquels le deuxième signal ($M_2$) de mesure est une fonction univoque de la grandeur (I) à mesurer et à composer le troisième signal ($M_3$) de mesure à partir des rameaux du deuxième signal ($M_2$) de mesure dans ces domaines d'univalence.

**4.** Procédé suivant l'une des revendications précédentes, qui consiste à déduire le troisième signal ($M_3$) de mesure du premier signal ($M_1$) de mesure et du deuxième signal ($M_2$) de mesure à l'aide d'une table de valeurs déterminée auparavant.

**5.** Procédé suivant l'une des revendications 1 à 3, qui consiste à calculer le troisième signal ($M_3$) de mesure à partir du premier signal ($M_1$) de mesure et du deuxième signal ($M_2$) de mesure.

**6.** Procédé suivant l'une des revendications précédentes de mesure d'un courant (I) électrique dans un domaine (MR) de mesure de courant prescrit dans un conducteur (2) de courant comprenant au moins deux éléments (3, 4) de Faraday entourant le conducteur (2) de courant dans lequel

a) un premier signal ($L_1$) lumineux polarisé linéairement passe au moins une fois dans un premier des deux éléments (3) de Faraday et d'une rotation du plan de polarisation de ce premier signal ($L_1$) lumineux on déduit le premier signal ($M_1$) de mesure du courant (I),
b) un deuxième signal ($L_2$) lumineux polarisé linéairement passe au moins une fois dans un deuxième des deux éléments (4) de Faraday et d'une rotation du plan de polarisation de ce deuxième signal ($L_2$) lumineux on déduit le deuxième signal ($M_2$) de mesure du courant (I).

**7.** Procédé suivant la revendication 6, dans lequel le deuxième signal ($L_2$) lumineux polarisé linéairement passe au moins une fois respectivement à la fois dans le premier élément (3) de Faraday et dans le deuxième élément (4) de Faraday.

**8.** Dispositif de mesure d'une grandeur (I) à mesurer dans un domaine (MR) de mesure prescrit, comprenant

a) un premier dispositif (5) de mesure destiné à produire un premier signal ($M_1$) de mesure, qui est une fonction univoque de la grandeur (I) à mesurer sur tout le domaine (MR) de mesure prescrit,
b) un deuxième dispositif (6) de mesure de production d'un deuxième signal ($M_2$) de mesure, qui est une fonction périodique de la grandeur (I) à mesurer avec une période ($P_2$) qui est inférieure au double de la longueur (|MR|) de l'intervalle du domaine (MR) à mesurer, et
c) une unité (12) de traitement de signal reliée aux deux dispositifs (5, 6) de mesure et déduisant du premier signal ($M_1$) de mesure et du deuxième signal ($M_2$) de mesure un troisième signal ($M_3$) de mesure qui, dans le domaine (MR) de mesure prescrit, est une fonction univoque de la grandeur (I) à mesurer et a au moins la même résolution de mesure que le deuxième signal ($M_2$) de mesure.

**9.** Dispositif suivant la revendication 8, dans lequel le premier signal ($M_1$) de mesure produit à partir du premier dispositif (5) de mesure est aussi, au moins sur tout le domaine (MR) de mesure prescrit, une fonction périodique de la grandeur (I) à mesurer.

**10.** Dispositif suivant la revendication 8 ou 9, dans lequel l'unité (12) de traitement du signal subdivise à l'aide du premier signal ($M_1$) de mesure le domaine (MR) de mesure en des domaines d'univalence sur tous lesquels le deuxième signal ($M_2$) de mesure est une fonction univoque de la grandeur (I) à mesurer, et compose le troisième signal ($M_3$) de mesure à partir des branches du deuxième signal ($M_2$) de mesure dans ces domaines d'univalence.

**11.** Dispositif suivant l'une des revendications 8 à 10, dans lequel l'unité (12) de traitement du signal comporte une table de valeurs déterminée auparavant pour déduire le troisième signal ($M_3$) de mesure à partir du premier signal ($M_1$) de mesure et du deuxième signal ($M_2$) de mesure.

**12.** Dispositif suivant l'une des revendications 8 à 10, dans lequel l'unité (12) de traitement du signal comporte des moyens arithmétiques de calcul du troisième signal ($M_3$) de mesure à partir du premier signal ($M_1$) de mesure et du deuxième signal ($M_2$) de mesure.

**13.** Dispositif suivant l'une des revendications 8 à 12 de mesure d'un courant (I) électrique dans un conducteur (2) de courant dans un domaine (MR) de mesure de courant prescrit dans lequel

a) le premier dispositif (5) de mesure comporte un premier élément (3) de Faraday entourant le conducteur (2) de courant et une première unité (7) d'exploitation qui, à partir d'une rotation du plan de polarisation d'un premier signal ($L_1$) lumineux polarisé linéairement, après que celui-ci est passé au moins une fois dans le premier élément (3) de Faraday, déduit le premier signal ($M_1$) de mesure du courant (I),

b) le deuxième dispositif (6) de mesure comporte au moins un deuxième élément (4) de Faraday entourant le conducteur (2) de courant et une deuxième unité (8) d'exploitation qui, à partir d'une rotation du plan de polarisation d'un deuxième signal ($L_2$) lumineux polarisé linéairement, après qu'il a passé au moins une fois dans au moins le deuxième élément (4) de Faraday, déduit le deuxième signal ($M_2$) de mesure du courant (I).

**14.** Dispositif suivant la revendication 13, dans lequel

a) le premier élément (3) de Faraday est un élément commun à la fois au premier dispositif (5) de mesure et au deuxième dispositif (6) de mesure,

b) les deux éléments- (3, 4) de Faraday sont montés optiquement en série par des moyens (14, 15, 16) optiques de liaison, et

c) le deuxième signal ($L_2$) lumineux passe dans le premier élément (3) de Faraday et dans le deuxième élément (4) de Faraday respectivement au moins une fois.

EP 0 864 098 B1

FIG 1

FIG 3

20

FIG 2

**FIG 4**

FIG 5

$$M_2 = \frac{T_{21} \cdot T_{22}}{T_{21} + T_{22}}$$

FIG 6

FIG 7